# EUROPEAN PATENT SPECIFICATION

(11) **EP 2 693 148 B1**
(45) Date of publication and mention of the grant of the patent: **27.05.2020**
(21) Application number: 12762986.3
(22) Date of filing: 30.03.2012
(51) Int. Cl.: F28D 20/00, F28F 23/02, H01L 35/30, H02N 11/00

(54) **HEAT STORAGE DEVICE, AND SYSTEM PROVIDED WITH HEAT STORAGE DEVICE**
WÄRMESPEICHERVORRICHTUNG UND SYSTEM MIT DER WÄRMESPEICHERVORRICHTUNG
DISPOSITIF DE STOCKAGE DE CHALEUR ET SYSTÈME POURVU D'UN DISPOSITIF DE STOCKAGE DE CHALEUR

(30) Priority: 30.03.2011 JP 2011075255
(43) Date of publication of application: 05.02.2014
(73) Proprietor: Tokyo University Of Science Educational Foundation Administrative Organization, Shinjuku-ku Tokyo 162-8601 (JP); Itoh Kikoh Co., Ltd., Nagoya-shi, Aichi 457-0806 (JP); Nippon Thermostat Co., Ltd., Kiyose-shi Tokyo 204-0003 (JP); Swcc Showa Cable Systems Co., Ltd., Tokyo 105-0001 (JP)
(72) Inventor: IIDA, Tsutomu, Tokyo 162-8601 (JP); MIZUNO, Kuniaki, Tokai-shi Aichi 476-0001 (JP); TAKIZAWA, Yukio, Tokai-shi Aichi 476-0001 (JP); DEGUCHI, Tetsuya, Tokai-shi Aichi 476-0001 (JP); SAWADA, Kazunori, Tokai-shi Aichi 476-0001 (JP); MITO, Yohiko, Tokyo 107-0052 (JP); NEMOTO, Takashi, Kiyose-shi Tokyo 204-0003 (JP); MINOWA, Masahiro, Tokyo 105-6013 (JP)
(74) Representative: Ström & Gulliksson AB
(86) International application number: PCT/JP2012/058613
(87) International publication number: WO 2012/133790

(56) References cited:
- EP-A1- 0 203 501
- EP-A1- 0 203 501
- DE-U1- 29 914 113
- DE-U1- 29 914 113
- FR-A1- 2 309 823
- FR-A1- 2 309 823
- GB-A- 1 497 042
- GB-A- 1 497 042
- JP-A- 11 044 495
- JP-A- 2008 089 186
- JP-A- 2008 089 239
- JP-A- 2008 224 066
- JP-A- 2011 521 192

## Description

### TECHNICAL FIELD

The present invention relates to a heat storage device provided with an alloy or mixed salt having a predetermined eutectic temperature, and to a system provided with the heat storage device. JP 2008 089239 A discloses a heat storage device according to the preamble of claim 1.

### BACKGROUND ART

In recent years, in response to increasing environmental issues, various means have been investigated to effectively utilize exhaust heat arising from production facilities in factories, power plants, automobiles and the like, as thermal energy. Such exhaust heat can be converted to a new energy form and utilized.

As a device for converting exhaust heat to a new energy form, for example, Patent Document 1 discloses a heat treatment device provided with a temperature setting layer which sets a predetermined temperature between two thermoelectric conversion modules which generate electricity from heat. Further, Patent Document 2 discloses a thermoelectric generation system provided with an intermediate heat transport loop which can control heat flow between a high temperature side and a generating element of a low temperature side.
Patent Document 1: Japanese Unexamined Patent Application, Publication No. 2008-34700
Patent Document 2: Japanese Unexamined Patent Application, Publication No. 2002-285274

JP 2008-089239 discloses a thin planar heat storage member constituted by placing a thin planar honeycomb structure composed of aluminum foil and opened at both faces of cells, inside of a bag body composed of a synthetic resin sheet, filling the bag body with a latent heat-type heat storage material, and closing the bag body in a state of dipping the thin planar honeycomb structure in the heat storage material.

WO 2009/138771 A1 discloses thermal energy storage systems and use of energy storable material such as phase change material in the provision of heating and/or cooling systems in, for example, domestic dwellings.

JP 2008-224066 A discloses a heat storage device comprising a flat heat storage body constituted by vertically disposing a flat heat storage container receiving the latent-heat heat storage agent, a planar heating element, a flat heat absorber, a heat storage body temperature detecting means, and a control device for controlling the planar heating element, the planar heating element is closely kept into contact with one face of the flat heat storage body, and the flat heat absorber is closely kept into contact with the opposite other face.

JP 11-044495 A discloses a heat storage device comprising a reserving tank in which a heating source is accommodated and a heat storage material filled into the reserving tank. A sugar alcohol, having the principal constituent of erythritol, mannitol or the like, is used as the heat storage material. An electric heater is used as the heating source. The side wall of the storage tank is provided with a bellows capable of being expanded and contracted in up-and-down in order to follow the volumetric change of the heat storage material.

JP 63-201494 A discloses a regenerative heat exchanger capable of taking out the heat of high temperature and low in heat loss by a method wherein a heat source side operating medium is made to flow from a center side heat accumulating member toward an outer peripheral side heat accumulating member while load side operating medium is made flow from the latter to the former.

DE 29914113 U1 discloses a stratified storage tank with a housing in the form of an upright cylinder which is provided on all sides with an insulation that surrounds a water storage tank.

GB 1497042 A discloses a thermal storage apparatus comprising a storage vessel having located therein at least one container containing a freezable fluid, means for heating the freezable fluid, and a refrigerant circuit containing a refrigerant.

CA 1081935 is a patent family member of FR 2309823 A1 that discloses a heat accumulator which has a heat exchanger embedded in a crystalline substance and has a maximum operating temperature greater than the melting point of the crystalline substance. The latter and the heat exchanger are integrated in a moulding bonded by means of crosslinked plastic.

EP 0203501 A1 discloses a latent heat storage apparatus for cooling purposes including a plurality of cells having equalized thermal response and allowing the cooling heat stored to be effectively taken out.

### DISCLOSURE OF THE INVENTION

### Problems to be Solved by the Invention

However, because the exhaust heat produced by production facilities in factories, power plants, automobiles and the like is subjected to strong temperature increases and decreases, the temperature is not produced in a stable manner, and therefore, there is the problem that it is not possible to stably provide the energy obtained by utilizing this exhaust heat.

Exhaust heat with such strong increases in temperature, if utilized as a heat source of an energy conversion device such as a thermoelectric conversion module or a sterling engine or the like, may cause the problem of breaking the energy conversion device.

Incidentally, for an alloy or mixed salt having a eutectic reaction, its temperature will increase when heated, and its temperature will drop when the heating is stopped, but in the vicinity of the eutectic point, the temperature changes are gradual. If a heat storage device using such an alloy or mixed salt can be provided between a heat source which generates exhaust heat, and an energy conversion device such as, for example, a thermoelectric conversion module or the like, heat within a fixed temperature range in the vicinity of the eutectic point can be stably provided to an energy conversion device.

The present invention was made in consideration of the above problem, and has the objective of providing a heat storage device which stores heat in a fixed temperature range and can stably store heat.

Further, the present invention has the objective of providing a system which stably operates the energy conversion device, by heat within a fixed temperature range released from the heat storage device.

Further, the present invention has the objective of providing an electric generator system which can maintain a fixed generation rate by heat within a fixed temperature range released from the heat storage device, in the case that the energy conversion device is a thermoelectric conversion module.

### Means for Solving the Problems

The first aspect of the present invention is a heat storage device which stores heat from a heat source, this heat being stored for operating an energy conversing device, this heat being used for operating an energy conversion device. Said heat storage device characterized by the features of claim 1.

The second aspect of the present invention is a heat storage device according to the first aspect, characterized in that the heat resistant frame filled with one type of eutectic alloy or eutectic mixed salt is a heat absorption section and a heat dissipation section or, among the heat resistant frames filled with the two or more eutectic alloys or eutectic mixed salts, the part of the heat resistant frame filled with the eutectic alloy (1) or eutectic mixed salts (1) having the highest eutectic temperature is the heat absorption section, and the part of the heat resistant frame filled with the eutectic alloy (2) or eutectic mixed salt (2) having the lowest eutectic temperature is a heat dissipation section.

The third aspect of the present invention is a heat storage device according to any one of the first or second aspects provided with a heat collection part.

The fourth aspect of the present invention is a heat storage device according to any one of the first to third aspects wherein the heat resistant frame is an expandable structure.

The fifth aspect of the present invention is a system characterized in having the heat storage device according to the second aspect, and an energy conversion device connected to the heat dissipation section.

The sixth aspect of the present invention is a system characterized in having the heat storage device according to the second aspect, and an energy conversion device connected to the heat dissipation section.

The seventh aspect of the present invention is a system according to the fifth or sixth aspect, characterized in that the energy conversion device is a thermoelectric conversion module.

The eight aspect of the present invention is a system according to the fifth or sixth aspect, characterized in that the energy conversion device is a Sterling engine.

The ninth aspect of the present invention is a system according to any one of the fifth to eighth aspects, having a thermal fuse and/or a cooling portion.

The tenth aspect of the present invention is a method of generating electricity with a thermoelectric module, by using the system according to the seventh aspect, storing heat by absorbing heat in the heat absorption section, and releasing heat from the heat dissipation section as a heat source.

The eleventh aspect of the present invention is a method of operating a Sterling engine using the system according to the eighth aspect, storing heat by absorbing heat in the heat absorption section, and releasing heat from the heat dissipation section as a heat source.

### Effects of the Invention

According to the present invention, it is possible to provide a heat storage device which stores heat within a fixed temperature range, and which can stably store heat.

Further, according to the present invention, it is possible to provide a system for stably operating the energy conversion device, by the heat within a fixed temperature range released from the heat storage device.

Furthermore, according to the present invention, in the case that the energy conversion device is a thermoelectric conversion module, it is possible to provide an electric generator system which can maintain a fixed generation rate by heat within a fixed temperature range released from the heat storage device.

### BRIEF DESCRIPTION OF THE DRAWINGS

Fig. 1 is a drawing schematically showing one example of a heat storage device according to an embodiment of the present invention.
Fig. 2 is a drawing showing one example of a eutectic temperature range of an alloy of the high temperature side and the low temperature side.
Fig. 3 shows a phase diagram of an Sn-Zn alloy which is one example of an alloy according to the present embodiment.
Fig. 4 is a drawing schematically showing a heat storage device according to Variation Example 1.
Fig. 5 is a drawing schematically showing a heat storage device according to Variation Example 2.
Fig. 6 is a drawing schematically showing a heat storage device according to Variation Example 3.
Fig. 7 is a drawing schematically showing a heat storage device according to Variation Example 4.
Fig. 8 is a drawing schematically showing one example of a thermal energy conversion system according to an embodiment of the present invention.
Fig. 9 is a drawing schematically showing a thermal energy conversion system according to a variation example.
Fig. 10 is a photomicrograph of the metallographic structure of a 30Sn-70Zn alloy.
Fig. 11 is a drawing schematically showing a thermal energy conversion system according to a variation example.
Fig. 12 is a drawing showing the temperature changes of a high temperature side and a low temperature side of a thermoelectric conversion module in a reference example, and the changes of the open-circuit voltage of the thermoelectric conversion module.
Fig. 13 is a drawing showing the positions for providing the thermocouples in the heat storage device in Example 1.
Fig. 14 is a drawing showing the temperature changes of the predetermined locations in Example 1.
Fig. 15 is a drawing showing the positions for providing the thermocouples in the heat storage device or thermal energy conversion system of Examples 2 to 9.
Fig. 16 is a drawing showing the temperature changes of the predetermined locations in the heat storage device in Example 2.
Fig. 17 is a drawing showing the temperature changes of the predetermined locations of the heat storage device in Example 3.
Fig. 18 is a drawing showing the temperature changes of the predetermined locations of the heat storage device in Example 4.
Fig. 19 is a drawing showing the temperature changes of the predetermined locations of the heat storage device in Example 5.
Fig. 20 is a drawing showing the temperature changes of the predetermined locations of the heat storage device in Example 6.
Fig. 21 is a drawing showing the temperature changes of the predetermined locations of the thermal energy conversion system of Example 7, and the changes of the open-circuit voltage of the thermoelectric conversion module.
Fig. 22 is a drawing showing the temperature changes of the predetermined locations of the thermal energy conversion system of Example 8, and the changes of the open-circuit voltage of the thermoelectric conversion module.
Fig. 23 is a drawing showing the temperature changes of the predetermined locations of the thermal energy conversion system of Example 9, and the changes of the open-circuit voltage of the thermoelectric conversion module.
Fig. 24 is a drawing showing the positions of providing the thermocouples in the thermal energy conversion system in Example 10.
Fig. 25 is a drawing showing the temperature changes of the predetermined locations of the thermal energy conversion system in Example 10.
Fig. 26 is a drawing schematically showing the thermal energy conversion system of Example 11.
Fig. 27 is a drawing showing the temperature changes of the predetermined locations of the thermal energy conversion system of Example 11, and the changes of the open-circuit voltage of the thermoelectric conversion module.
Fig. 28 is a drawing schematically showing the thermal energy conversion system of Example 12.
Fig. 29 is a drawing showing the temperature changes of the predetermined locations of the thermal energy conversion system of Example 12, and the changes of the open-circuit voltage of the thermoelectric conversion module.
Fig. 30 is a drawing schematically showing the thermal energy conversion system of Example 13.
Fig. 31 is a drawing showing the temperature changes of the predetermined locations of the thermal energy conversion system of Example 13, the changes of the open-circuit voltage of the thermoelectric conversion module, and the changes in the amount of extension of the heat storage frame.
Fig. 32 is a drawing schematically showing the thermal energy conversion system of Example 14.
Fig. 33 is a drawing showing the temperature changes of the predetermined locations of the thermal energy conversion system of Example 14, and the changes of the open-circuit voltage of the thermoelectric conversion module.
Fig. 34 is a drawing schematically showing the thermal energy conversion system of Example 15.
Fig. 35 is a drawing showing the temperature changes of the predetermined locations of the thermal energy conversion system of Example 15, and the changes of the open-circuit voltage of the thermoelectric conversion module.

### EXPLANATION OF REFERENCE NUMERALS

- 1, 1A, 1B: thermal energy conversion system,
- 10, 10A, 10B, 10C, 10D: heat storage device,
- 11, 11A, 11B, 11C: heat resistant frame,
- 11a: partitioning wall,
- 12: heat absorption-side heat storing section,
- 13: heat dissipation-side heat storing section,
- 14: heat collection part,
- 14a: fin,
- 15: thermal fuse,
- 15a: fusible alloy,
- 15b: retaining member,
- 16: opening,
- 20: thermoelectric conversion module,
- 20a: thermoelectric conversion layer,
- 20b: electrode layer,
- 25: gap,
- 30: cooling device,
- 100: heat source,
- 110: thermal energy conversion system,
- 120: chimney,
- 130: burner,
- 140: aerofin tube,
- 141A, 141B: heat storage frame,
- 142A, 142B: heat absorption-side heat storing section,
- 143A, 143B: heat dissipation-side heat storing section,
- 150: thermoelectric conversion module,
- 160: cooling device,
- 170: thermal energy conversion system,
- 180: heat storage frame,
- 181: heat absorption-side heat storing section,
- 182: heat dissipation-side heat storing section,
- 190: thermal fuse,
- 191: fusible alloy,
- 192A, 192B: retaining member,
- 200: thermoelectric conversion module,
- 210: cooling device,
- 220: thermal energy conversion system,
- 230: heat storage frame,
- 231: heat absorption-side heat storing section,
- 232: heat dissipation-side heat storing section,
- 233A, 233B: quartz glass plate
- 234: quartz glass rod
- 240: thermoelectric conversion module,
- 250: cooling device,
- 260: thermal energy conversion system,
- 270: cooling device,
- 280: thermal energy conversion system,
- 290: heat storage frame,
- 291: heat absorption-side heat storing section,
- 292: heat dissipation-side heat storing section,
- 293: fireproof rope,
- 300: thermoelectric conversion module,
- 310: cooling device

### PREFERRED MODE FOR CARRYING OUT THE INVENTION

Below, embodiments of the invention are explained in detail based on the figures. Further, in the below explanations of the embodiments, for identical constitutions, the same reference numbers are used and explanations thereof are omitted or simplified.

### First Embodiment

The heat storage device of the present invention is a device for storing heat obtained from a heat source with an unstable temperature as latent heat.

The heat storage device of the present invention stores heat by an alloy or mixed salt having a predetermined eutectic temperature, and this alloy or mixed salt may be of one type, or may be a plurality of types.

The heat storage device 10 according to the first embodiment of the present invention explained below, as one example of the heat storage device of the present invention, uses two types of alloy.

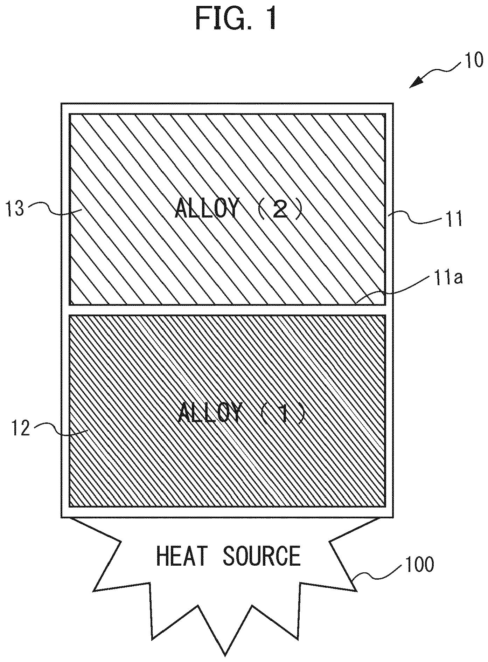

Fig. 1 is a drawing schematically showing one example of the heat storage device 10 according to an embodiment of the present invention.

The heat storage device 10 is provided with a box shaped heat resistant frame 11, a heat absorption-side heat storing section 12 formed by filling an alloy (1) into the inner section of the heat resistant frame 11 of the heat source 100 side, and a heat dissipation-side heat storing section 13 formed by filling an alloy (2) into the inner section of the heat resistant frame 11, and adjoining the heat absorption-side heat storing section 12 via the partitioning wall 11a of the heat resistant frame 11.

### Constitution of the Heat Storage Device 10

### [Heat Resistant Frame]

The heat resistant frame 11 is a box shaped body, and has a space of a predetermined volume in its inner section. The heat resistant frame 11 has a partitioning wall 11a which divides into two equal parts the inner section of the heat resistant frame 11 in the lengthwise direction. Namely, the heat resistant frame 11 has two spaces of a predetermined volume which adjoin via a partitioning wall 11a. Further, the heat resistant frame 11 according to the present embodiment is formed as a box shaped body, however, the present invention is not limited to a box shaped body, and may be a shape which can be filled with an alloy, such as a tubular shape. Furthermore, the inner section of the heat resistant frame 11 according to the present embodiment is divided into two equal parts, however, the present embodiment is not limited to being divided into two equal parts, and may be divided into a volume ratio in accordance with the characteristics of the filled alloy and the like. Moreover, in the case that the alloy (1) and the alloy (2) are the same type of alloy, it is possible to exclude the partitioning wall 11a. In this case, the heat resistant frame 11 will have one space.

Further, in the heat resistant frame 11, the face which is on the opposite side of the face which contacts the heat absorption-side heat storing section 12 in the heat dissipation-side heat storing section 13 may be wider than the face which contacts the heat absorption-side heat storing section 12. In this way, for example, in the case that the heat storage device 10 is connected with the thermoelectric conversion module, one heat storage device 10 may adjoin a plurality of thermoelectric conversion modules.

Further, the heat resistant frame 11 may be formed of a heat resistant material of a predetermined thickness (for example, SS, SUS SCH, SCS, and the like).

The heat resistant frame 11 is provided with a box section wherein two spaces are formed, and having one open face, and a cover section which covers the one open face of the box section.

The heat absorption-side heat storing section 12 is formed by filling the alloy (1) into the space of the heat source 100 side of the two spaces of the heat resistant frame 11.

The heat dissipation-side heat storing section 13 is formed by filling the alloy (2) into the space at the opposite side of the heat source 100 side of the two spaces of the heat resistant frame 11.

In the present embodiment, for the heat absorption-side heat storing section 12 and the heat dissipation-side heat storing section 13, the alloy (1) or the alloy (2) are directly filled into the heat resistant frame 11, however, the present invention is not limited to this, and the heat absorption-side heat storing section 12 and the heat dissipation-side heat storing section 13 may respectively be provided with separate frames, where the alloy (1) or the alloy (2) are filled into these frames, and the frames into which the alloy (1) or the alloy (2) is filled may be removably provided in the heat resistant frame 11.

### [Alloy]

The eutectic temperature of the alloy (1) of the heat absorption-side heat storing section 12 is higher than the eutectic temperature of the alloy (2) of the heat dissipation-side heat storing section 13.

The alloy (1) absorbs fluctuations in the temperature and heat amount of the heat arising from the heat source 100, and provides heat within a predetermined temperature range to the alloy (2).

The alloy (2) absorbs temperature changes of the heat provided from the alloy (1), and stores the heat as heat within a predetermined temperature range.

The alloy (1) and the alloy (2) are alloys having predetermined eutectic temperatures, and alloys with eutectic temperatures included within the temperature range of the heat generated by the heat source 100 are selected.

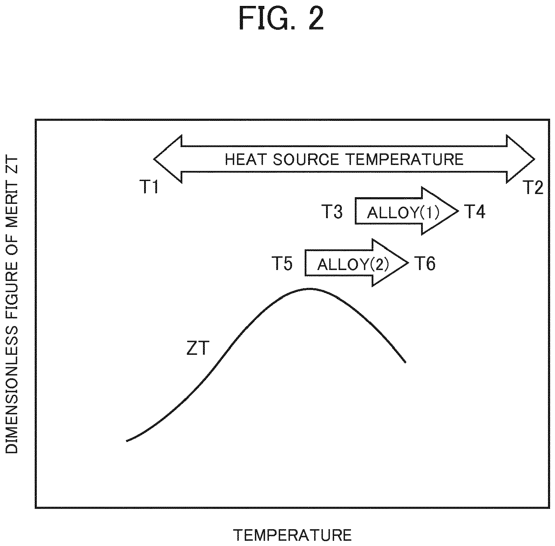

For example, in the case that the temperature range of the heat generated by the heat source 100 is the range from T1 to T2 in Fig. 2, and the dimensionless figure of merit ZT of the thermoelectric conversion module connected to the heat storage device 10 changes as indicted in Fig. 2 along with temperature changes, as the alloy (1), it is preferable to select one with a eutectic temperature within the range of T3 to T4 in Fig. 2, and as the alloy (2), it is preferable to select one with a eutectic temperature within the range of T5 to T6 in Fig. 2. By selecting the alloy (1) and the alloy (2) in this way, it is possible to transmit to the thermoelectric conversion module heat within a temperature range such that the dimensionless figure of merit ZT is maximized.

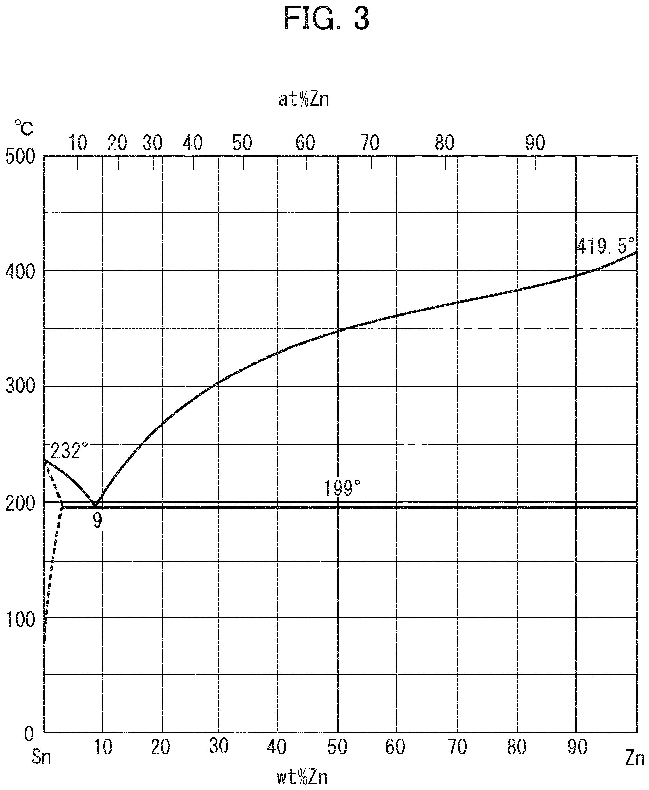

Fig. 3 shows a phase diagram of an Sn-Zn alloy which is one example of the alloy according to the present embodiment.

As shown in Fig. 3, the eutectic temperature of the Sn-Zn alloy which is one example of an alloy according to the present embodiment is 199°C.

The alloy, for example in the case that its eutectic temperature is 199°C such as for the Sn-Zn alloy, absorbs heat in the case that the temperature of the alloy is heated to higher than 199°C, and releases heat in the case that it is cooled to lower than 199°C.

The heat absorption amount and heat dissipation amount by the alloy can be adjusted by changing the heat capacity (specific heat × specific weight × volume) + fusion enthalpy. For example, in the case that it is desired to increase the heat absorption amount and heat dissipation amount, it is possible to increase the heat absorption amount and heat dissipation amount of the alloys by composing the alloy of metals having greater specific weights and greater fusion enthalpies, or by increasing the volume.

In the present embodiment, the alloys of the heat absorption-side heat storing section 12 and the heat dissipation-side heat storing section 13 are each different alloys, however, the present invention is not limited to this, and it is possible to make the alloys of the heat absorption-side heat storing section 12 and the heat dissipation-side heat storing section 13 the same. In this case, it is possible to not provide the partitioning wall 11a of the heat resistant frame, so that the heat resistant frame 11 has one space.

Further, in the present embodiment, the space of the inner section of the heat resistant frame 11 is divided into two equal parts, and these two spaces are filled with two types of alloy, however, the present invention is not limited to this, and the inner section of the heat resistant frame 11 may be divided into 3 or more spaces, and each of these spaces may be respectively filled with different alloys. In this case, the alloys are filled in order of higher eutectic temperature from the heat source 100 side.

Further, in the present embodiment, alloys are filled into the heat absorption-side heat storing section 12 and the heat dissipation-side heat storing section 13, however, the present embodiment is not limited to this, and it is possible to fill mixed salts into the heat absorption-side heat storing section 12 and the heat dissipation-side heat storing section 13.

### (Specific Examples of the Alloys and Mixed Salts)

Specific examples of the alloys and mixed salts are indicated below.

Table 1 shows specific examples of the alloy (1) and the alloy (2) for low temperature use. Low temperature use refers to an alloy used in the case that the temperature of the heat generated by the heat source 100 is up to a maximum of 400°C.

Table 2 shows specific examples of alloys for low temperature use other than the alloys shown in Table 1, and mixed salts for low temperature use.

**[Table 1]**

| low temperature use (up to 400°C) |
|---|
| • JISH 5301 zinc alloy (eutectic temperature : about 300 to 400°C) |
| 1 type ZDC1 (Zn-Al-Cu system) |
| 2 types ZDC2 (Zn-Al system) and the like |
| • JISH 5401 white metal (Sn alloy) (eutectic temperature : about 200 to 300°C) |
| 1 type WJ1 (Sn-Sb-Cu system) |
| 5 types WJ5 (Sn-Cu-Zn system) and the like |

**[Table 2]**

| Low temperature use (up to 400°C) | | | |
|---|---|---|---|
| alloy | | mixed salt | |
| | eutectic temperature | | eutectic temperature |
| Sn-Zn | 199°C | KNO₃-NaNO₂ | 141°C |
| Al-Sn | 228°C | NaNO₃-KNO₃ | 218°C |
| Al-Zn | 382°C | NaNO₂-KNO₂ | 219°C |
| | | NaNO₃-NaNO₂ | 221°C |

Table 3 shows specific examples of the alloy (1) and the alloy (2) for medium temperature use. Medium temperature use refers to alloys used in the case that the temperature of the heat generated by the heat source 100 is up to a maximum of 800°C.

Table 4 shows specific examples of alloys for medium temperature use other than those shown in Table 3 and mixed salts for medium temperature use.

**[Table 3]**

| intermediate temperature use (400 to 800°C) |
|---|
| • JISH 5202 aluminum alloy (eutectic temperature : about 500 to 600°C) |
| AC1B (Al-Cu4MgTi system) |
| AC4C (Al-Si7MgFe system) |
| AC5A (Al-Cu4Ni2Mg2 system) and the like |
| • JISH 5302 aluminum alloy die cast |
| ADC12 (Al-Si-Cu system) |
| ADC14 (Al-Si-Cu-Mg system) and the like |
| • JISH 5203 magnesium alloy (eutectic temperature : about 400 to 500°C) |
| 2 types MC2C (Mg-Al9Zn system) |
| 11 types MC11 (Mg-Zn6Cu3Mn system) and the like |
| • JISH 5303 magnesium alloy die cast |
| MDC1B (Mg-Al9Zn1 system) |
| MDC5 (Mg-Al2Mn system) and the like |

**[Table 4]**

| intermediate temperature use (400 to 800°C) | | | |
|---|---|---|---|
| alloy | | mixed salt | |
| | eutectic temperature | | eutectic temperature |
| Al-Ge | 424°C | CaCl₂-NaCl | 501°C |
| Al-Si | 577°C | BaCl₂-CaCl₂ | 617°C |
| Al-Cu | 584°C | NaCl-BaCl₂ | 656°C |
| Cu-Al | 584°C | NaCl-KCl | 660°C |
| Al-Ca | 616°C | (ternary system) | |
| Al-Ni | 640°C | CaCl₂-NaCl-BaCl₂ | 500 to 650°C |
| Fe-Al | 655°C | KCl-NaCl-BaCl₂ | 550 to 660°C |
| Al-Co | 657°C | Na₂B₄O₇-NaCl-BaCl₂ | 650 to 730°C |
| Al-Zr | 660°C | | |
| Al-B | 660°C | | |
| Ti-Al | 665°C | | |
| Al-U | 730°C | | |

Table 5 shows specific examples of the alloy (1) and alloy (2) for high temperature use. High temperature use refers to an alloy used in the case that the temperature of the heat generated by the heat source 100 is up to a maximum of 1000°C.

Table 6 shows specific examples of alloys for high temperature use other than those shown in Table 5.

**[Table 5]**

| high temperature use (800 to 1000°C) |
|---|
| • JISH 5120 copper and copper alloy (eutectic temperature : about 800 to 1000°C) |
| brass casting 1 type CAC201 (Cu-Zn system) |
| high strength bronze cast CAC301 (Cu-Zn-Mn-Fe-Al system) |
| phosphor bronze casting CAS502A (Cu-Sn-P system) |
| aluminum bronze casting 1 type CAC701 (Cu-Al-Fe-Ni-Mn system) and the like |
| • JISH 5801 titanium and titanium alloy (eutectic temperature : about 900 to 1100°C) |
| 12 types (Ti-Pd system) |
| 60 types (Ti-Al-V system) and the like |

**[Table 6]**

| high temperature use (800 to 1000°C) | |
|---|---|
| alloy | |
| | eutectic temperature |
| Cu-Si | 802°C |
| Al-Cr | 940°C |
| Al-Mn | 990°C |

### Method of Manufacturing the Heat Storage Device 10

A method of manufacturing the heat storage device 10 is explained.

First, a heat resistant frame 11 having two spaces forming a heat absorption-side heat storing section 12 and a heat dissipation-side heat storing section 13 is produced divided into a box section and a cover section.

Next, depending on the temperature range of the heat generated by the heat source 100, the type of the alloy (1) and the alloy (2) are selected.

The two types of simple metals composing the alloy (1) are combined in a predetermined weight ratio, are melted by heating in a crucible furnace, and poured into the space forming the heat absorption-side heat storing section 12 in the box section. Further, the two types of simple metals composing the alloy (2) are combined in a predetermined weight ratio, are melted by heating in a crucible furnace, and poured into the space forming the heat dissipation-side heat storing section 13 in the box section.

Next, the cover section is installed in the box section.

Further, in order to prevent heat loss, the heat storage device 10 may be wrapped with a heat insulating material.

### Mechanism of Heat Transmission in the Heat Storage Device 10

In a state where heat is not generated by the heat source 100, the alloy (1) of the heat absorption-side heat storing section 12 and the alloy (2) of the heat dissipation-side heat storing section 13 are in the solid state.

When heat is generated by the heat source 100, first, the temperature of the alloy (1) increases. Once the alloy (1) increases its temperature to the eutectic temperature, this temperature is held for a prescribed time, and afterward this, it enters a solid-liquid coexistence state, and the increase in temperature becomes gradual.

The heat of the alloy (1) is transmitted to the alloy (2). Once the alloy (2) increases its temperature to the eutectic temperature, this temperature is held for a prescribed time, and afterward this, it enters a solid-liquid coexistence state, and the increase in temperature becomes gradual.

In the case that a thermoelectric conversion module is installed in the heat storage device 10, the heat of this alloy (2) is transmitted to the thermoelectric conversion module.

Further, the heat storage device 10 is capable of absorbing temperature fluctuations of the heat, by means of the heat absorption / heat dissipation reaction in the vicinity of the eutectic temperature, but in the case that the alloy (1) and/or alloy (2) have a eutectic reaction and a eutectoid reaction, they are also capable of absorbing temperature fluctuations of the heat by means of the heat absorption / heat dissipation reaction in the vicinity of the eutectoid temperature.

### Variation Example 1 of the Heat Storage Device

Next, the Variation Example 1 of the heat storage device is explained.

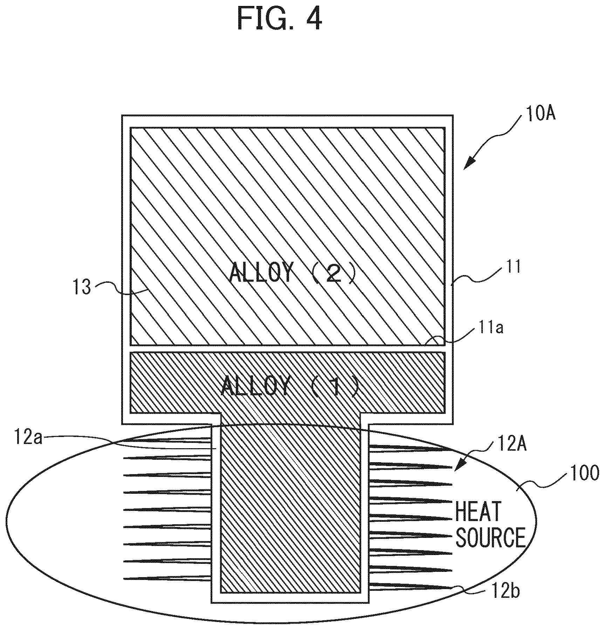

Fig. 4 is a drawing schematically showing the heat storage device 10A according to Variation Example 1.

In the heat storage device 10A, the heat absorption-side heat storing section 12A is provided with a heat collection part 12b. The volume ratio of the alloy (1) to the alloy (2) in the heat storage device 10A is approximately 3:7.

The heat absorption-side heat storing section 12A is provided with a section where an alloy (1) is filled into a space of the heat source 100 side of the two spaces divided by the partitioning wall 11a of the heat resistant frame 11, a tubular body 12a filled with the alloy (1), and a heat collection part 12b formed with a helical form at the outer circumference of the tubular body 12a.

The heat collection part 12b is a part which absorbs the heat of a gas or a liquid, and is a fin which increases the area in contact with a gas. The heat absorbed by the heat collection part 12b is transmitted to the tubular body 12a, and is absorbed by the alloy (1) filled into the tubular body 12a. By providing the heat collection part 12b, in the case of absorbing heat from a gas or a liquid, it is possible to increase the efficiency of heat absorption.

Further, Fig. 4 shows a fin as one specific form of the heat collection part 12b, however, the form of the heat collection part 12b is not limited to a fin, and for example, may be a tubular body in the form of a bellows.

### Variation Example 2 of the Heat Storage Device

Next, the Variation Example 2 of the heat storage device is explained.

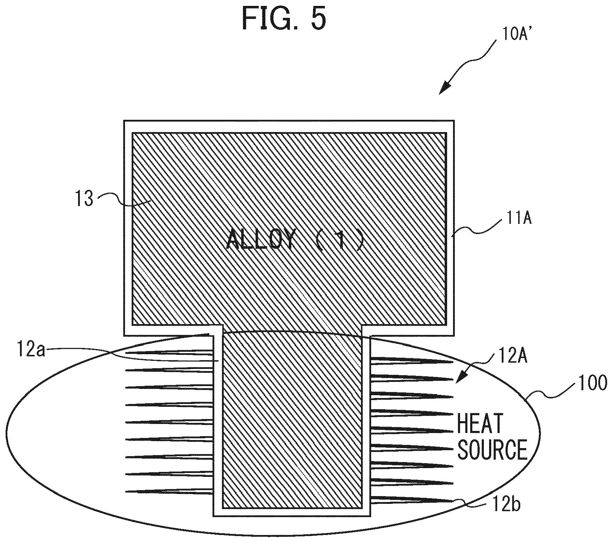

Fig. 5 is a drawing schematically showing a heat storage device 10A' according to Variation Example 2.

In Variation Example 2 the heat resistant frame is not provided with a partitioning wall, and it differs from Variation Example 1 in the point that one type of alloy is filled into the space of the heat resistant frame and the tubular body.

The heat storage device 10A' is provided with a heat resistant frame body 11A having one space, a tubular body 12a, and a heat collection part 12b formed in a spiral shape at the outer periphery of the tubular body 12a, and the spaces of the heat resistant frame 11A and the tubular body 12a are filled with the same type of alloy (1).

### Variation Example 3 of the Heat Storage Device

Next, Variation Example 3 of the heat storage device is explained.

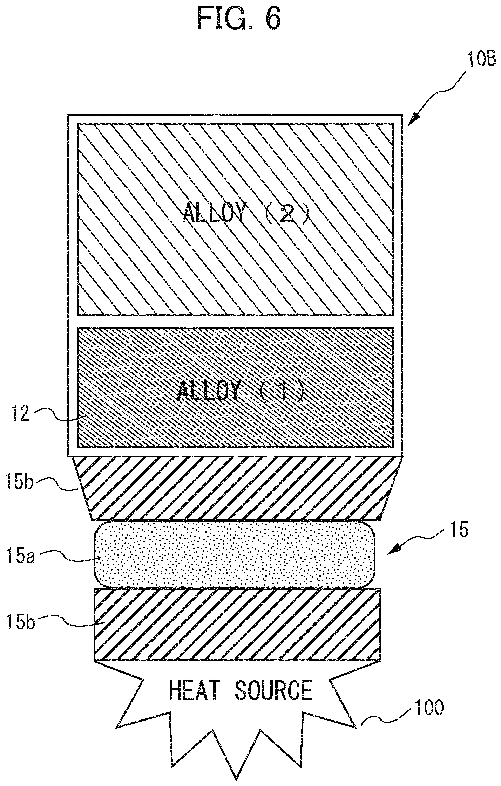

Fig. 6 is a drawing schematically showing the heat storage device 10B according to Variation Example 3.

The heat storage device 10B is provided with a thermal fuse 15 at the heat source 100 side of the heat absorption-side heat storing section 12. The volume ratio of the alloy (1) and the alloy (2) in the heat storage device 10B is approximately 4:6.

The thermal fuse 15 is provided with a fusible alloy 15a which fuses at a predetermined temperature, and retaining members 15b which retain the fusible alloy 15a.

The fusible alloy 15a is formed of an alloy which fuses in the vicinity of the temperature at which the alloy (1) is capable of absorbing heat. The fusion point of the fusible alloy 15a is higher than the eutectic temperature of the alloy (1), and lower than the fusion point of the alloy (1).

The retaining member 15b is formed of a material having at least a higher fusion point than the alloy (1) for high temperature use (maximum 1000°C), for example copper or the like.

When the temperature of the heat generated by the heat source 100 is a temperature at which the alloy (1) can absorb heat, the thermal fuse 15 absorbs heat and transmits this heat to the alloy (1), and when the temperature of the heat generated by the heat source 100 exceeds the temperature at which the alloy (1) can absorb heat, the fusible alloy 15a fuses, and the transmission of heat to the alloy (1) is stopped.

The heat storage device 10B shown in Fig. 6 is provided with a thermal fuse 15 between the heat storage device 10 and the heat source 100, however, in the case that a thermoelectric conversion module is connected to the heat storage device 10, this thermal fuse 15 may be provided between the heat storage device 10 and the thermoelectric conversion module.

### Variation Example 4 of the Heat Storage Device

Next, Variation Example 4 of the heat storage device is explained.

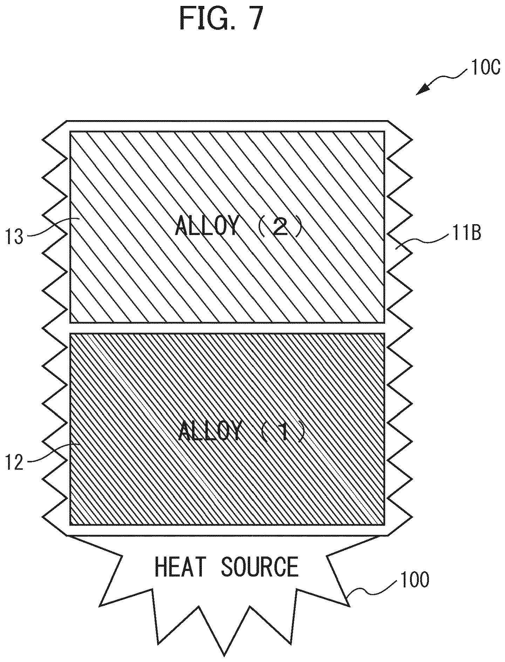

Fig. 7 is a drawing schematically showing the heat storage device 10C according to Variation Example 4.

In the heat storage device 10C, the heat resistant frame 11B is a bellows-shaped expansion pipe (a bellows). In the case that the heat from the heat source 100 is absorbed from the heat absorption-side heat storing section 12 of the heat storage device 10C, and discharged from the heat dissipation-side heat storing section 13, the volumes of the alloy (1) and the alloy (2) expand more than in the solid state. Further, a gas in the heat resistant frame 11B also expands by heating. Because the heat resistant frame 11B is capable of elongating when the alloy and the gas in such a heat resistant frame 11B expand, it is possible to prevent damage to the heat resistant frame, and leaking of the alloy from the heat resistant frame.

Further, Fig. 7 shows that the heat resistant frame is a bellows-shaped expansion pipe (bellows), however, it is not limited to this, so long as it is an expandable structure.

### Second Embodiment

The thermal energy conversion system according to the second embodiment of the present invention is a system which generates electricity by utilizing the heat obtained from the heat source.

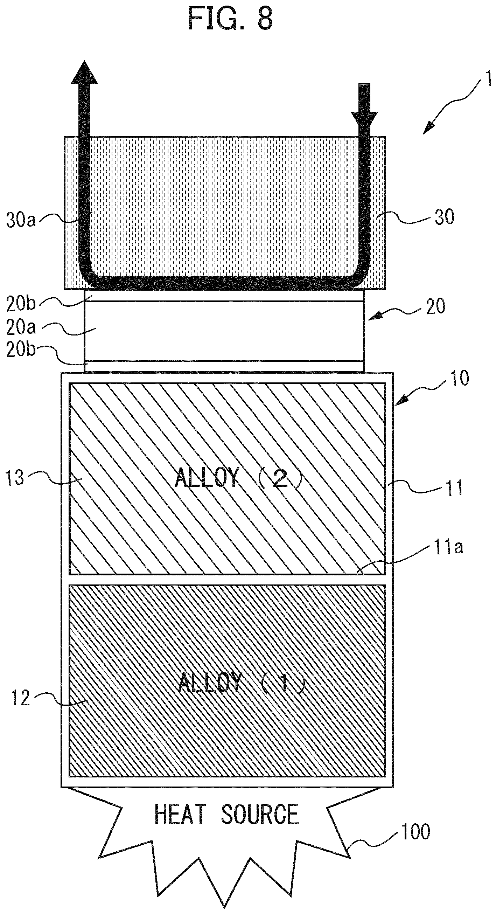

Fig. 8 is a drawing schematically showing one example of the thermal energy conversion system 1 according to an embodiment of the present invention.

The thermal energy conversion system 1 is provided with a heat storage device 10 facing a heat source 100 which generates heat, a thermoelectric conversion module 20 in contact with the heat storage device 10 at the opposite side of the heat source 100, and a cooling device 30 in contact with the thermoelectric conversion module 20. Further, the thermal energy conversion system 1 according to the present embodiment is provided with a cooling device 30, however, in the present invention the cooling device 30 is not an essential constituent.

The heat storage device 10 has the same constitution as in the first embodiment, and it explanation is omitted.

The thermoelectric conversion module 20 is provided with a thermoelectric conversion layer 20a, and a pair of electrode layers 20b which sandwich the thermoelectric conversion layer 20a, one of which is in contact with the heat storage device 10, and the other is in contact with the cooling device 30. The thermoelectric conversion module 20 converts heat to electric power by utilizing the Seebeck effect generating an electromotive force corresponding to a temperature difference, this temperature difference formed by one of the electrode layers 20b being held at a high temperature, and the other held at a low temperature.

As the thermoelectric conversion material constituting the thermoelectric conversion layer 20a, for example, a silicon germanium (SiGe) system material may be used for high temperature applications, and an oxide system, cluster system, LAST (Ag, Pb, Sb, Te system), TAGS (Te, Ag, Ge, Sb system) system material may be used for high temperature applications, and a magnesium silicide (Mg₂Si) system, PbTe system, Co-Sb system, Zn-Sb system, Mn-Si system material may be used for intermediate temperature applications, and bismuth-tellurium (Bi₂Te₃) system material may be used for low temperature applications.

An insulating layer may be provided between the heat storage device 10 and the electrode layer 20b, and between the cooling device 30 and the electrode layer 20b.

The cooling device 30 is provided with a cooling pipe 30a through which a coolant which is a liquid or a gas is made to flow (the arrow mark in Fig. 8), and the cooling tube is abutted with one of the electrode layer 20b of the thermoelectric conversion module 20, and the cooling tube 30a is cooled by the circulating refrigerant. The cooling device 30 may make use of the well known techniques. For example, the cooling device 30 may make use of the cooling device provided with the refrigerating cooling heat exchanger shown in Japanese Unexamined Patent Application, First Publication No. 2008-159762, or the heat exchanger provided with the heat exchange tube wherein a fluid is circulated, shown in Japanese Unexamined Patent Application, First Publication No. 2005-321156.

Further, in general, the thermal contact resistance between two solids depends on the surface roughness of the contact surfaces of the respective solids, and the contact pressure between the solids, and the like. Accordingly, in order to optimize the heat transmission from the heat storage device 10 to the thermoelectric conversion module 20, and the heat transmission from the thermoelectric conversion module 20 to the cooling device 30, it is preferable to reduce the surface roughness of the contact faces, and increase the contact pressure.

### Variation Example 1 of the Thermal Energy Conversion System

Next, Variation Example 1 of the thermal energy conversion system is explained.

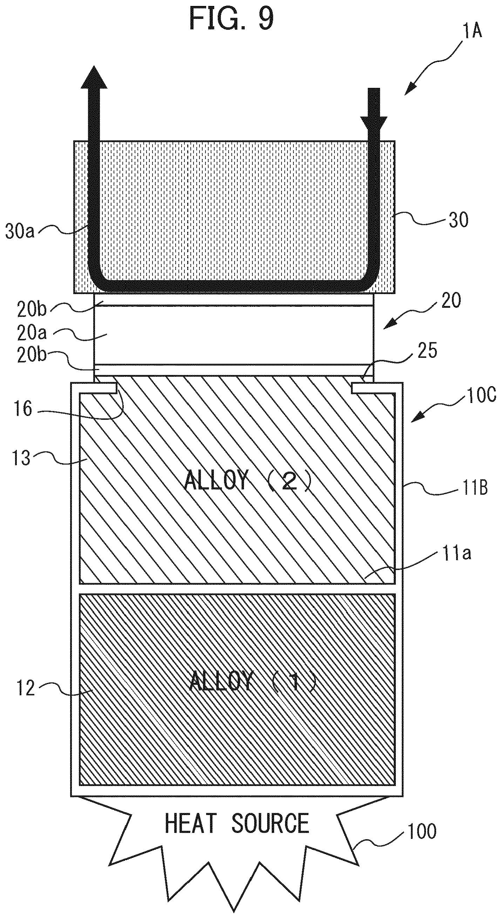

Fig. 9 is a drawing schematically showing the thermal energy conversion system 1A according to the variation example.

The thermal energy conversion system 1A differs from the thermal energy conversion system 1 in the point that an opening 16 is formed on a face facing the thermoelectric conversion module 20 of the heat resistant frame 11C, at the heat storage device 10D (refer to Fig. 8).

A minute gap 25 may be present between the heat storage device 10D and the thermoelectric conversion module 20. In the thermal energy conversion system 1A, for the alloy (2) of the heat dissipation-side heat storage section 13, an alloy which does not discharge a liquid phase from the gap 25 because, at the eutectic temperature, a dendrite structure (columnar structure) prevents excess melting of the liquid phase (for example 30Sn-70Zn), is adapted.

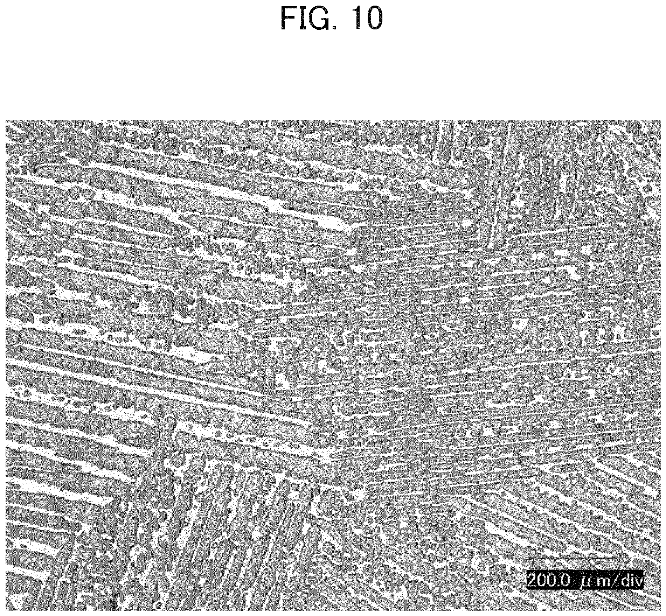

Fig. 10 is a photomicrograph of the metal structure of the 30Sn-70Zn alloy.

Herein, each of the numbers attached to the disclosure of the 30Sn-70Zn alloy indicates the content ratio, and for example the disclosure of a 30Sn-70Zn alloy indicates that the content ratio of Sn is 30%, and the content ratio of Zn is 70%. Below, the numbers attached to the disclosures of the alloys have the same meaning.

In the thermal energy conversion system 1A, the alloy (2) maintains its temperature for a predetermined time once the temperature increases to the eutectic temperature, and after this, it reaches a state where solid and liquid coexist, wherein the dendrite phase and the liquid phase are mixed, and the dendrite phase seals the gap, preventing excessive discharge of the liquid phase. Further, the liquid phase wets the electrode 20b and facilitates heat transmission of the alloy (2) and the electrode layer 20b.

### Variation Example 2 of the Thermal Energy Conversion Device

Next, Variation Example 2 of the thermal energy conversion system is explained.

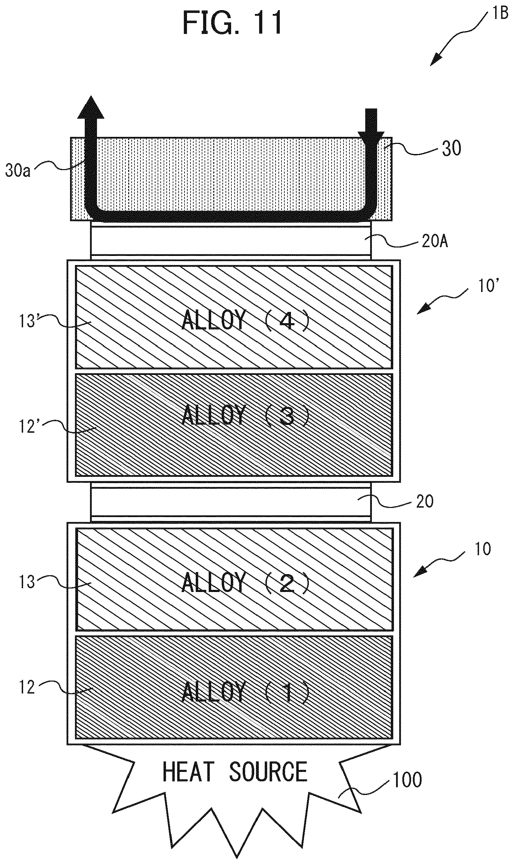

Fig. 11 is a drawing schematically showing the thermal energy conversion system 1B according to the variation example.

The thermal energy conversion system 1B differs from the thermal energy conversion system 1 (refer to Fig. 8) in the point that at the low temperature side of the thermoelectric conversion module 20, the heat storage device 10' and the thermoelectric conversion module 20A are connected, after which the cooling device 30 is contacted.

The heat storage device 10' differs from the heat storage device 10 (refer to Fig. 1) in the point that it is filled with the alloy (3) at the heat absorption-side heat storing section 12', and filled with the alloy (4) at the heat dissipation-side heat storing section 13'.

The alloy (1) and the alloy (2), or the alloy (3) and the alloy (4), may be the same kind of alloy, or may be different alloys. Further, in the case that the alloys (1) to (4) are respectively different alloys, they are preferably alloys such that the order of the alloys (1) to (4) from the heat source 100 side is by higher eutectic point.

In the thermal energy conversion system 1B, the thermoelectric conversion material of the thermoelectric conversion module 20 is for intermediate and high temperature use (for example, a Mg₂Si system material), and the thermoelectric conversion material of the thermoelectric conversion module 20A is preferably for low temperature use (for example, a Bi₂Te₃ system material).

### Variation Example 3 of the Thermal Energy Conversion System

Next, Variation Example 3 of the thermal energy conversion system is explained.

The thermal energy conversion system according to Variation Example 3 is provided with a Sterling engine instead of the thermoelectric conversion module 20.

The thermal energy conversion system according to Variation Example 3 is a system which operates a Sterling engine using as a heat source the heat obtained from a heat source.

The Sterling engine is provided with a cylinder, and a reciprocating moving piston inside the cylinder.

In the thermal energy conversion system according to Variation Example 3, a heat storage device or cooling device contacts the wall surface of the cylinder, and by repeating the expansion and compression of the gas inside the cylinder, the piston is made to reciprocate, and the thermal energy is converted into kinetic energy.

### EXAMPLES

First, a Reference Example is explained.

In the Reference Example, the heat storage device is not provided, the high temperature side of the thermoelectric conversion module is heated, the cooled side is cooled, and the temperature changes of the high temperature side and the low temperature side, and the open-circuit voltage of the thermoelectric conversion module were measured over time.

In the Reference Example, the following module was used as the thermoelectric conversion module.
Product name: Thermo Module
Model No.: T150-60-127
Manufacturer name: S. T. S. Company
Constitution:
1. Thermoelectric element: Bi-Te system (actually measured element size: approximately □1.3 x 1.5 mm)
2. Number of elements: 254 (127 pairs)
3. Module size: 39.6 x 39.6 x 4.16 (mm)

Further, in the Reference Example, a low carbon steel plate of a thickness of 10 mm is disposed at the high temperature side of the thermoelectric conversion module, and a water cooled low carbon steel plate box is disposed at the low temperature side, and the low carbon steel plate at the high temperature side was intermittently heated by a burner.

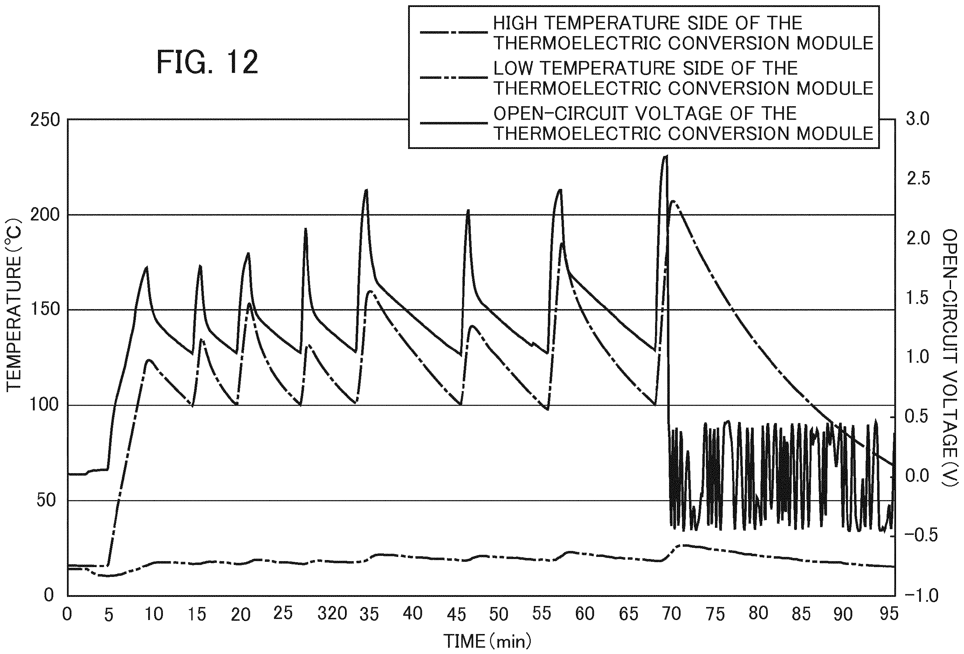

Fig. 12 is a drawing showing the temperature changes of the high temperature side and the low temperature side of the thermoelectric conversion module in the Reference Example, and the changes of open-circuit voltage of the thermoelectric conversion module.

The long-and-short dashed line indicates the temperature changes of the high temperature side of the thermoelectric conversion module.

The long-and-two-short dashed line indicates the temperature changes at the low temperature side of the thermoelectric conversion module.

The solid line indicates the changes in the open-circuit voltage of the thermoelectric conversion module.

As shown in Fig. 12, the temperature of the high temperature side of the thermoelectric conversion module undergoes severe changes, and it could be confirmed that the output of the open-circuit voltage of the thermoelectric conversion module also undergoes severe changes due to these temperature changes at the high temperature side. Further, it was possible to confirm that when the temperature of the high temperature side exceeded 200°C, the thermoelectric module was damaged.

Below, Examples of the present invention are presented and discussed in detail. Further, the present invention is not at all limited by the following examples.

In Examples 1 to 6 explained below, a thermocouple was provided connected to a measuring device (Graphtec Co., midi LOGGER GL200) at predetermined locations of the heat storage device of the embodiments, the heat absorption-side heat storing section of the heat storage device was heated by the heat source, and the temperature fluctuations of the predetermined locations over time were measured. Further, in Examples 7 to 10, in addition to the temperature fluctuations of the predetermined locations of the thermal energy conversion system, the open-circuit voltage of the thermoelectric conversion module was measured.

### Example 1

Example 1 is an example using the heat storage device 10A' (refer to Fig. 5) according to the Variation Example 2.

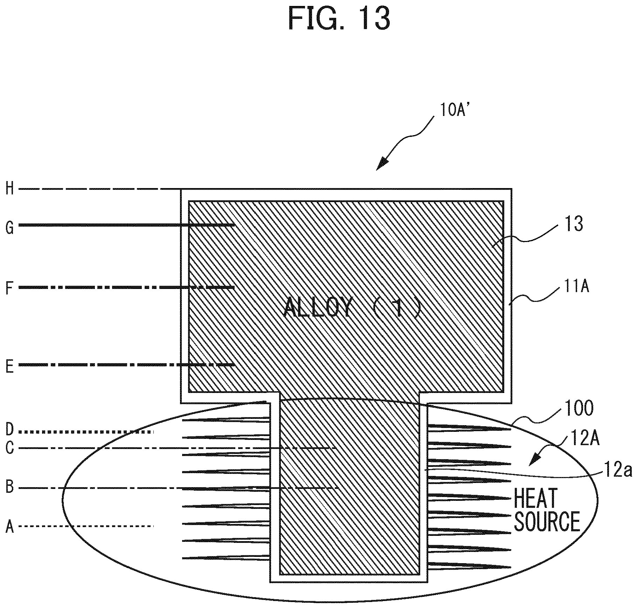

Fig. 13 is a drawing showing the positions for providing the thermocouples on the heat storage device 10A' in Example 1.

The thermocouple provided at the measurement location A (the dotted line in Fig. 13) measures the temperature changes in the central section of the heat source.

The thermocouple provided at the measurement location B (the long-and-short dashed line in Fig. 13) measures the temperature changes of the alloy (1) filled into the central section of the tubular body 12a.

The thermocouple provided at the measurement location C (the long-and-two-short dashed line in Fig. 13) measures the temperature changes of the alloy (1) filled into the vicinity of the heat resistant frame 11A of the tubular body 12a.

The thermocouple provided at the measurement location D (the thick dotted line in Fig. 13) measures the temperature changes of the heat source in the vicinity of the heat resistant frame 11A.

The thermocouple provided at the measurement location E (the thick long-and-short dashed line in Fig. 13) measures the temperature changes of the heat source side of the alloy (1) filled into the vicinity of the tubular body 12a of the heat resistant frame 11A.

The thermocouple provided at the measurement location F (the thick long-and-two-short dashed line in Fig. 13) measures the temperature changes of the alloy (1) filled into the central section of the heat resistant frame 11A.

The thermocouple provided at the measurement location G (the solid line in Fig. 13) measures the temperature changes of the alloy (1) filled into the vicinity of the heat radiating side of the heat resistant frame 11A.

The thermocouple provided at the measurement location H (the broken line in Fig. 13) measures the temperature changes at the heat dissipation side of the heat resistant frame 11A.

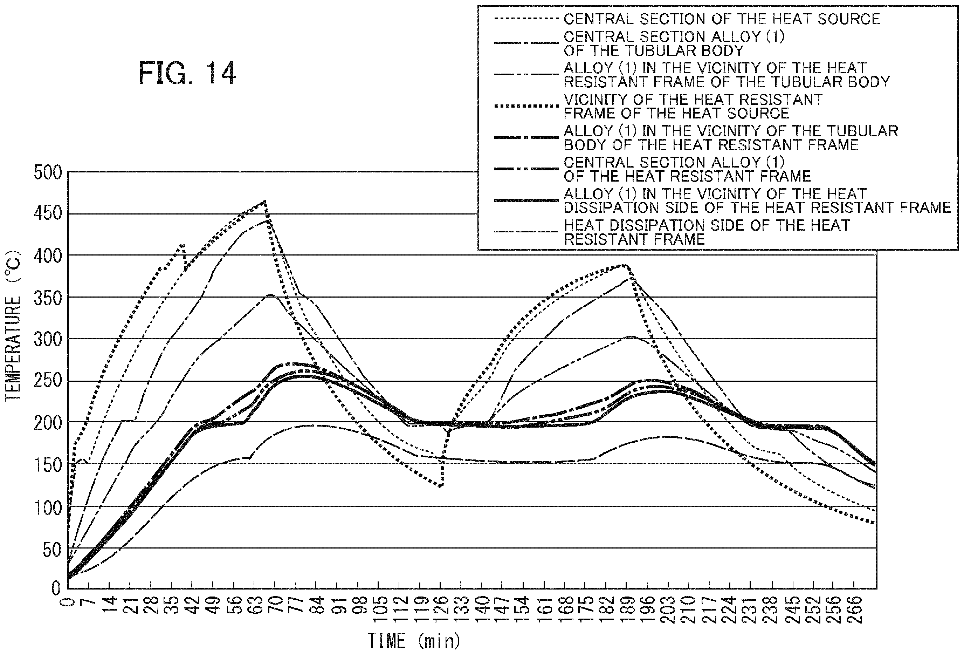

Fig. 14 is a drawing showing the temperature changes of the predetermined locations in Example 1. In Fig. 14, each of the lines indicates the following.

The dotted line indicates the temperature changes of the central section of the heat source measured at the measurement location A.

The long-and-short dashed line indicates the temperature changes of the alloy (1) filled into the central section of the tubular body 12a measured at the measurement location B.

The long-and-two-short dashed line indicates the temperature changes of the alloy (1) filled into the vicinity of the heat resistant frame 11A of the tubular body 12a measured at the measurement location C.

The thick dotted line indicates the temperature changes in the vicinity of the heat resistant frame 11A of the heat source measured at the measurement location D.

The thick long-and-short dashed line indicates the temperature changes of the alloy (1) filled into the vicinity of the tubular body 12a of the heat resistant frame 11A measured at the measurement location E.

The thick long-and-two-short dashed line indicates the temperature changes of the alloy (1) filled into the central section of the heat resistant frame 11A measured at the measurement location F.

The solid line indicates the temperature changes of the alloy (1) filled into the vicinity of the heat release side of the heat resistant frame 11A measured at the measurement location G.

The broken line indicates the temperature changes of the heat dissipation side of the heat resistant frame 11A measured at the measurement location H.

In Example 1, 50Sn-50Zn was used as the alloy (1), and was intermittently heated by the heat source.

As shown in Fig. 14, by heating for about 60 min, the temperature of the heating section increased to 450 to 470°C, but the alloy (1) filled into the vicinity of the heat dissipation side of the heat resistant frame 11A once rose to 250 to 270°C, but after this, held a temperature within a fixed range (about 199°C which is the eutectic temperature of the 50Sn-50Zn) for 50 to 60 min.

Accordingly, it was possible to confirm that the heat storage device of the present invention can store heat within a fixed temperature range.

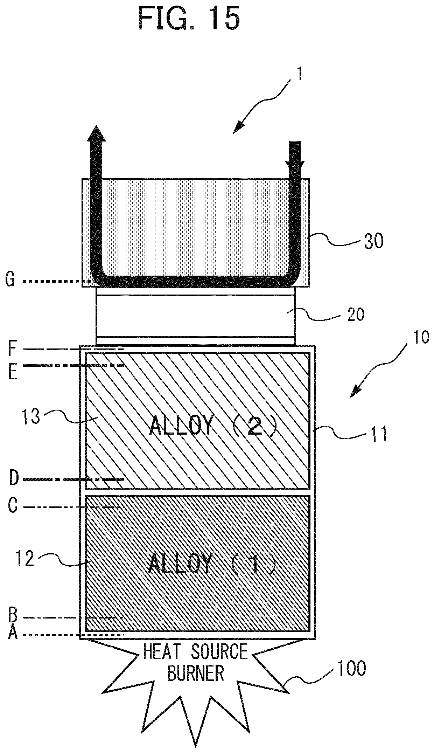

Fig. 15 is a drawing showing the positions for providing the thermocouples for the heat storage device and the thermal energy conversion system in Examples 2 to 9.

The thermocouple provided at the measurement location A (the dotted line in Fig. 15) measures the temperature changes in the heating section heated by the burner.

The thermocouple provided at the measurement location B (the long-and-short dashed line in Fig. 15) measures the temperature changes of the heat source side of the alloy (1).

The thermocouple provided at the measurement location C (the long-and-two-short dashed line in Fig. 15) measures the temperature changes of the alloy (2) side of the alloy (1).

The thermocouple provided at the measurement location D (the thick long-and-short dashed line in Fig. 15) measures the temperature changes of the alloy (1) side of the alloy (2).

The thermocouple provided at the measurement location E (the thick long-and-two-short dashed line in Fig. 15) measures the temperature changes of the side opposite to the alloy (1) side of the alloy (2).

The thermocouple provided at the measurement location F (the broken line in Fig. 15) measures the temperature changes of side opposite to the heating section of the heat resistant frame 11.

The thermocouple provided at the measurement location G (the thick dotted line in Fig. 15) measures the temperature changes of cooling section cooled by the coolant of the cooling device 30.

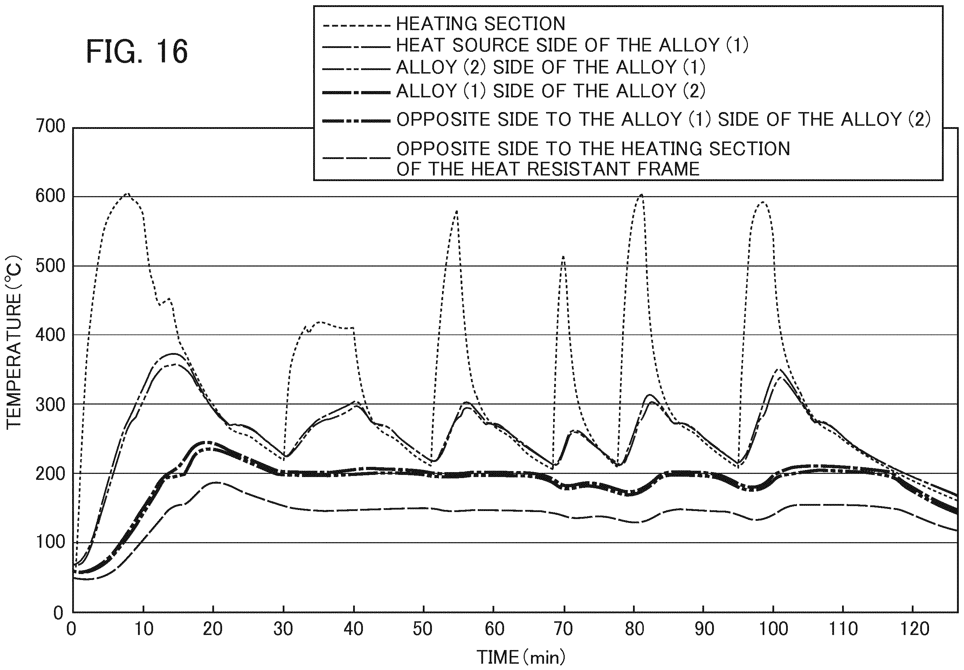

Figs. 16 to 23 are drawings showing the temperature changes and open-circuit voltage changes at predetermined locations in each of the examples, and the lines in each of the figures are as follows.

The dotted line indicates the temperature changes of the heating section measured at the measurement location A.

The long-and-short dashed line indicates the temperature changes of the heat source side of the alloy (1) measured at the measurement location B.

The long-and-two-short dashed line indicates the temperature changes of the alloy (2) side of the alloy (1) measured at the measurement location C.

The thick long-and-short dashed line indicates the temperature changes of the alloy (1) side of the alloy (2) measured at the measurement location D.

The thick long-and-two-short dashed line indicates the temperature changes of the side opposite to the alloy (1) side of the alloy (2) measured at the measurement location E.

The broken line indicates the temperature changes of the side opposite to the heating section of the heat resistant frame 11 measured at the measurement location F.

The thick dotted line indicates the temperature changes of the coolant of the cooling device 30 measured at the measurement location G.

The solid line indicates the changes of the open-circuit voltage of the thermoelectric conversion module 20.

### Example 2

Examples 2 to 7 are examples using the heat storage device 10 according to the first embodiment (refer to Fig. 1).

Fig. 16 is a drawing showing the temperature changes of the predetermined locations of the heat storage device 10 in Example 2.

In Example 2, the alloys (1) and (2) were respectively filled into two spaces of 100 mm x 100 mm x 50 mm in the heat resistant frame, and a 15Al-85Zn alloy was used as the alloy (1), and a 30Sn-70Zn alloy was used as the alloy (2), and intermittent heating was carried out with a burner.

As shown in Fig. 16, by heating for 4 or 5 min, the temperature of the heating portion increased to 500 to 600°C, but the temperature change of the alloy (1) with respect to this temperature change of the heating portion was gradual, and once the temperature of the alloy (2) increases to the eutectic point of the 30Sn-70Zn alloy (199°C), it is held within a fixed temperature range (about 199°C). Further, the alloy (2) was held within a fixed temperature range (about 199°C) for about 20 to 30 min after the burner was turned off and the heating was stopped.

Accordingly, it was possible to confirm that the heat storage device of the present invention was able to store heat within a fixed temperature range.

### Example 3

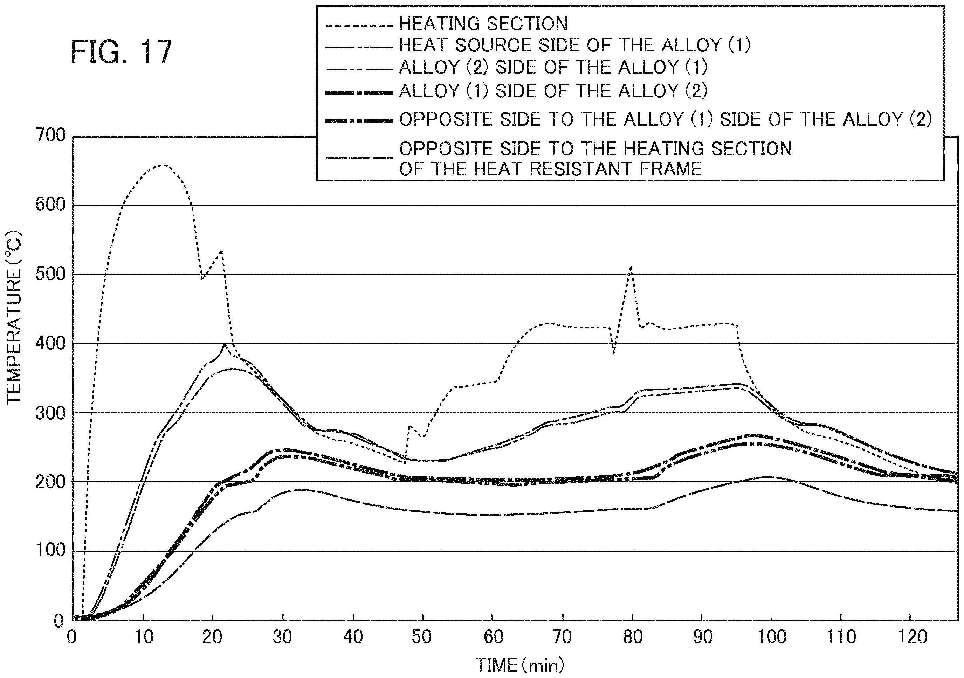

Fig. 17 is a drawing showing the temperature changes of the predetermined locations of the heat storage device 10 in Example 3.

In Example 3, the alloys (1) and (2) were respectively filled into two spaces of 100 mm x 100 mm x 50 mm in the heat resistant frame, and a 15Al-85Zn alloy was used as the alloy (1), and a 30Sn-70Zn alloy was used as the alloy (2), and continuous heating was carried out with a burner.

As shown in Fig. 17, by heating for 30 to 35 min, even when the temperature of the alloy (1) reached 300 to 400°C, the alloy (2) was held within a fixed temperature range (about 199°C which is the eutectic temperature of the 30Sn-70Zn alloy) for 30 to 40 min.

Accordingly, it was possible to confirm that the heat storage device of the present invention was able to store heat within a fixed temperature range.

### Example 4

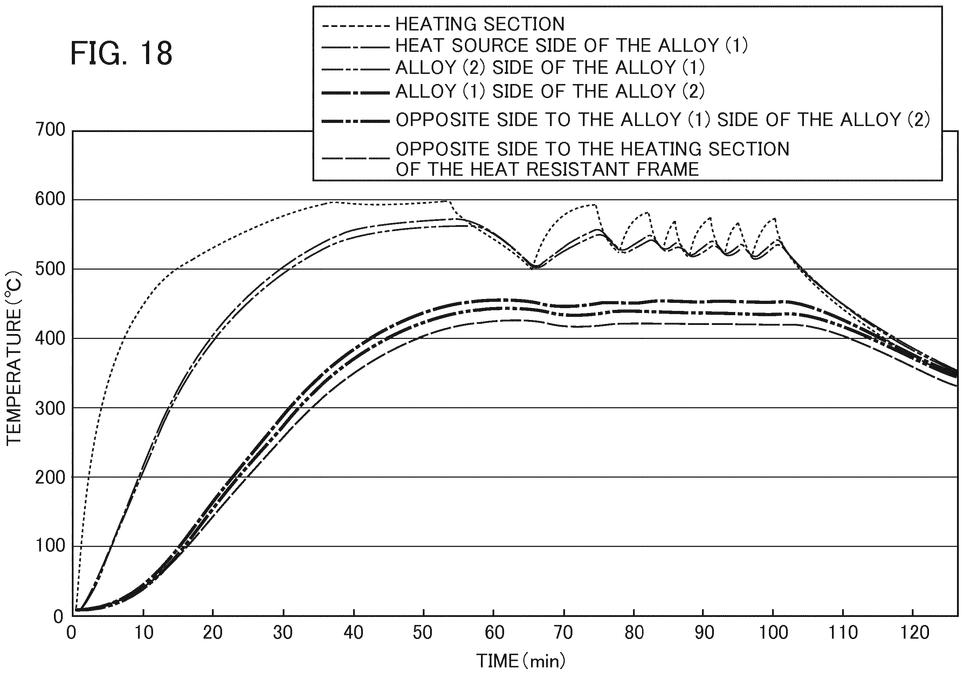

Fig. 18 is a drawing showing the temperature changes of the predetermined locations of the heat storage device 10 in Example 4.

In Example 4, the alloys (1) and (2) were respectively filled into two spaces of 100 mm x 100 mm x 50 mm in the heat resistant frame, and an 86Al-11Si-3Cu alloy was used as the alloy (1), and an 80Al-20Mg alloy was used as the alloy (2), and intermittent heating was carried out with a burner.

As shown in Fig. 18, by heating for 4 to 5 min, even when the temperature of the alloy (1) reached 520 to 580°C, the alloy (2) was held within a fixed temperature range (about 450°C which is the eutectic temperature of the 80Al-20Mg alloy) for 30 to 40 min

Accordingly, it was possible to confirm that the heat storage device of the present invention was able to store heat within a fixed temperature range.

### Example 5

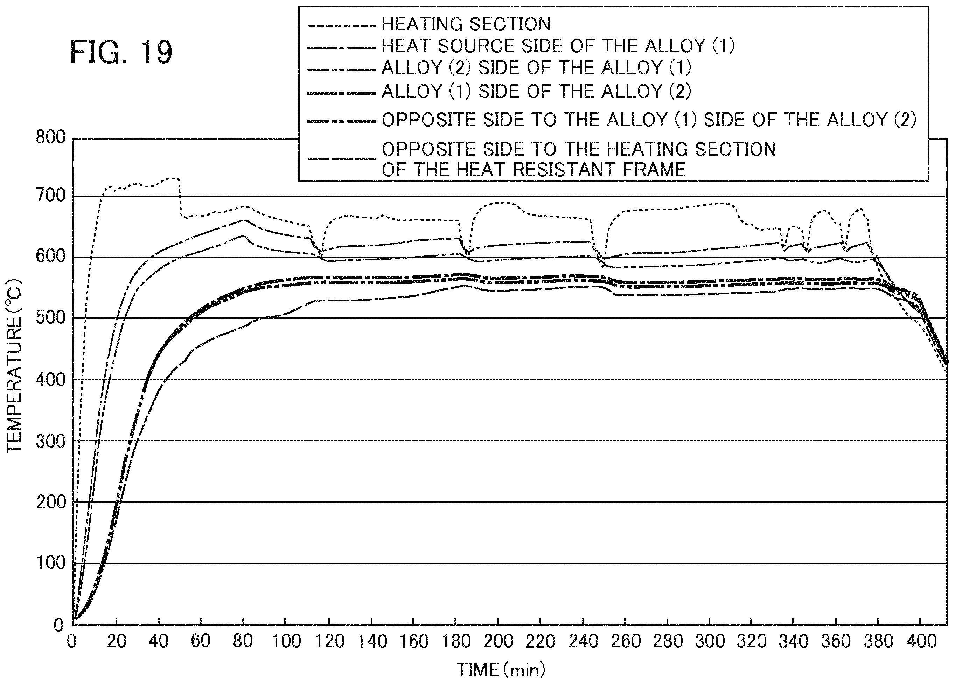

Fig. 19 is a drawing showing the temperature changes of the predetermined locations of the heat storage device 10 in Example 5.

In Example 5, the alloys (1) and (2) were respectively filled into two spaces of 100 mm x 100 mm x 50 mm in the heat resistant frame, and an 80Al-20Ni alloy was used as the alloy (1), and a 93Al-7Si alloy was used as the alloy (2), and intermittent heating was carried out with a burner.

As shown in Fig. 19, by heating for 40 to 50 min, even when the temperature of the alloy (1) reaches 600 to 700°C, because the heat was absorbed at the eutectic point of the alloy (1) of the high temperature side, the alloy (2) was held within a fixed temperature range (about 577°C which is the eutectic temperature of the 93Al-7Si alloy).

Accordingly, it was possible to confirm that the heat storage device of the present invention was able to store heat within a fixed temperature range.

### Example 6

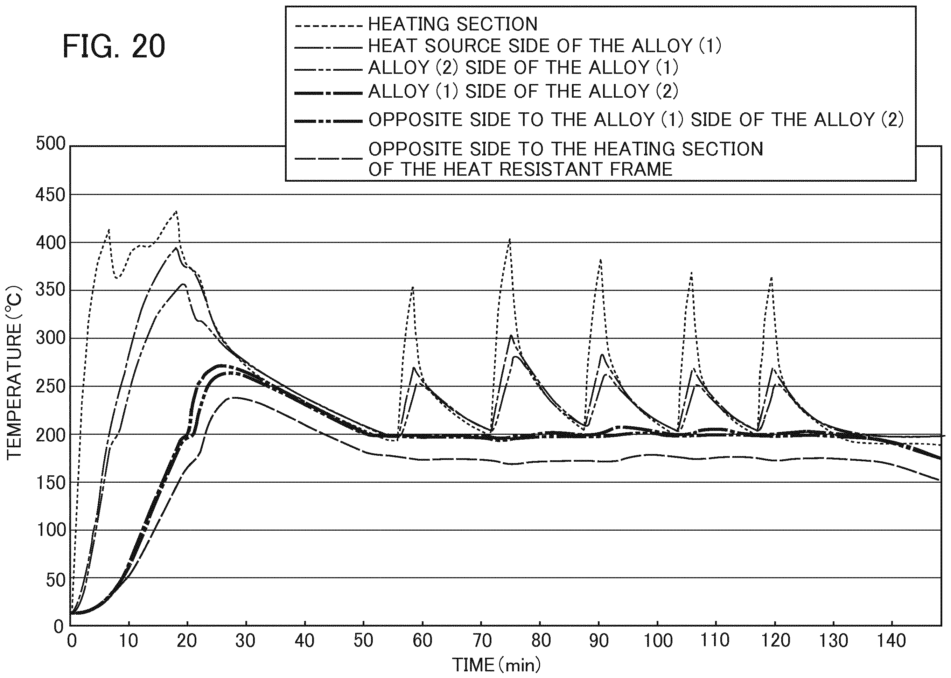

Fig. 20 is a drawing showing the temperature changes at the predetermined locations of the heat storage device 10 in Example 6.

In Example 6, the alloys (1) and (2) were respectively filled into two spaces of 100 mm x 100 mm x 50 mm in the heat resistant frame, and a 30Sn-70Zn alloy was used as the alloy (1) and the alloy (2), and intermittent heating was carried out with a burner.

As shown in Fig. 20, by heating for 2 to 3 min, the temperature of the heating portion reached 300 to 400°C, but the temperature change of the alloy (1) was gradual with respect to the temperature change of the heating portion, and once the temperature of the alloy (2) increases to the eutectic temperature of the 30Sn-70Zn alloy (199°C), it is held within a fixed temperature range (about 199°C). Further, the time during which the temperature is held within a fixed range is short compared to Example 2, however, the alloy (2) was held within a fixed temperature range (about 199°C) for 10 to 15 min after the burner was turned off and the heating stopped.

### Example 7

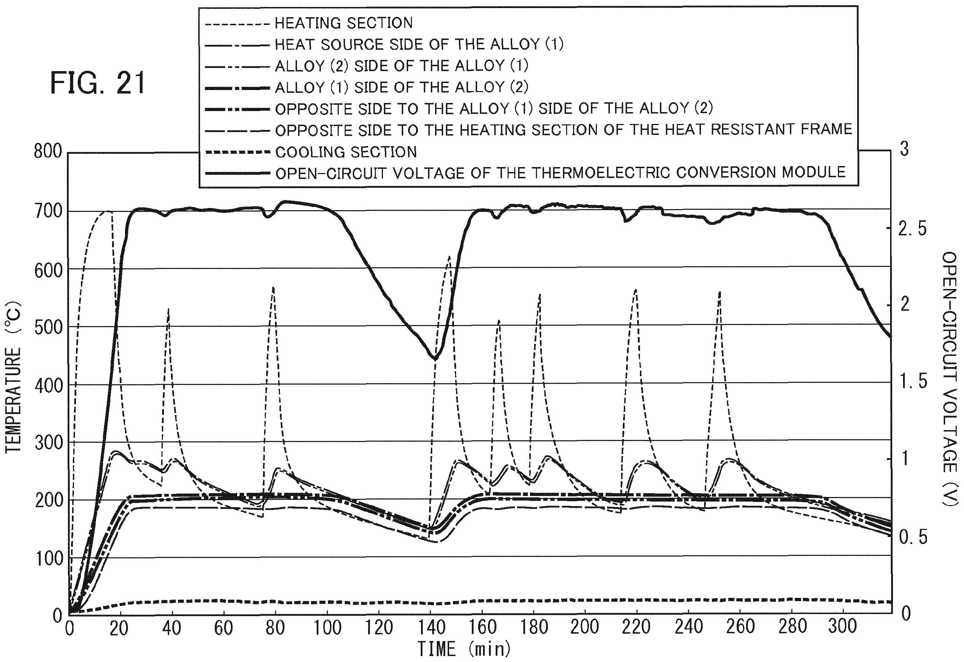

Fig. 21 is a drawing showing the temperature changes at the predetermined locations of the thermal energy conversion system 1 in Example 7, and the changes of the open-circuit voltage of the thermoelectric conversion module 20.

In Example 7, the alloys (1) and (2) were respectively filled into two spaces of 100 mm x 100 mm x 50 mm in the heat resistant frame, and a 15Al-85Zn alloy was used as the alloy (1), and a 30Sn-70Zn alloy was used as the alloy (2), and intermittent heating was carried out with a burner.

Further, in Example 7, the following module was used as the thermoelectric conversion module 20.
Product name: Thermo·Module
Model No.: T150-60-127
Manufacturer: S. T. S. Company
Constitution:
   1. Thermoelectric element: Bi-Te system (actual measured size: approximately □1.3 x 1.5 mm)
   2. Number of elements: 254 (127 pairs)
   3. Module size: 39.6 x 39.6 x 4.16 (mm)

Further, a thermally conductive sheet (graphite sheet) was used at the contact face of the electrode of the thermoelectric module 20 and the heat storage device 10

Further, grease (Dow Corning Toray Co. Ltd.: SC102 COMPOUND (thermally conductive material)) was applied to the electrode of the cooling device 30 side of the thermoelectric module 20.

As shown in Fig. 21, in the interval of about 20 min to about 100 min, and the interval of about 160 min to 280 min from the heating start time (0 min), the alloy (2) was held within a fixed temperature range (around 199°C which is the eutectic temperature of 30Sn-70Zn), and the open-circuit voltage of the thermoelectric module 20 was maintained at about 2.5 V, therefore, it was possible to confirm that the open-circuit voltage of the thermoelectric module 20 follows the temperature of the alloy (2).

### Example 8

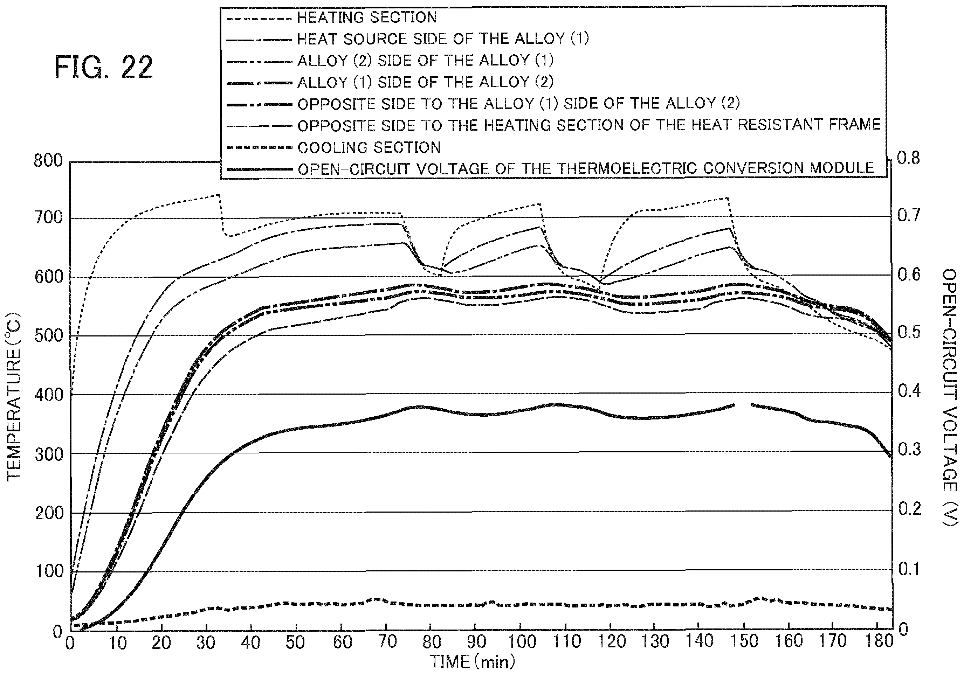

Fig. 22 is a drawing showing the temperature changes of the predetermined locations of the thermal energy conversion system 1 in Example 8, and the changes of the open-circuit voltage of the thermoelectric conversion module 20.

In Example 8, the alloys (1) and (2) were respectively filled into two spaces of 100 mm x 100 mm x 50 mm in the heat resistant frame, and an 80Al-20Ni alloy was used as the alloy (1), and a 93Al-7Si alloy was used as the alloy (2), and intermittent heating was carried out with a burner.

Further, in Example 8, the following module was used as the thermoelectric conversion module 20.
Product name: Unireg Type Mg₂Si Thermoelectric Conversion Module
Model number: prototype
Manufacturer: Nippon Thermostat Co. Ltd.
Constitution:
   1. Thermoelectric element: Mg₂Si (element size: 4 mm□ x 10 mm)
   2. Number of elements: 9
   3. Module size: 28 x 28 x 12 (mm)

Further, grease (Dow Corning Toray Co. Ltd.: SC102 COMPOUND (thermally conductive material)) was applied to the electrode of the cooling device 30 side of the thermoelectric module 20.

As shown in Fig. 22, in the interval of about 150 min from the start of heating (0 min), the heating portion made three heating iterations exceeding 600 to 700°C, and it was possible to confirm that during these intervals (about 150 min), the alloy (2) was held within a fixed temperature range (about 577°C which is the eutectic temperature of 93Al-7Si), and the open-circuit voltage of the thermoelectric module 20 was maintained at about 0.35 V.

Further, it was possible to confirm that the alloy (2) was held within a fixed temperature range (about 577°C) for a period of 30 min after the burner was turned off and the heating was stopped, and the open-circuit voltage of the thermoelectric module 20 was maintained at about 0.35 V.

### Example 9

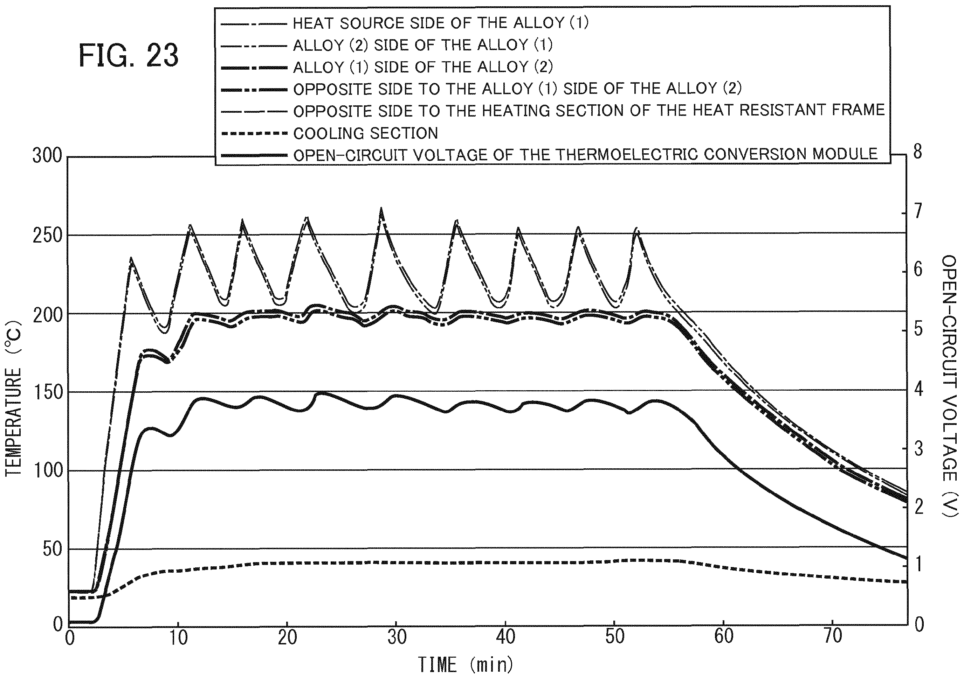

Fig. 23 is a drawing showing the temperature changes of the predetermined locations of the thermal energy conversion system 1 in Example 9, and the changes of the open-circuit voltage of the thermoelectric conversion module.

In Example 9, the alloys (1) and (2) were respectively filled into two spaces of 60 mm x 60 mm x 15 mm of the heat resistant frame, and a 15Al-85Zn alloy was used as the alloy (1), and a 30Sn-70Zn was used as the alloy (2), and intermittent heating was applied with a burner.

Further, in Example 9, the same module as in Example 7 was used as the thermoelectric conversion module 20.

As shown in Fig. 23, in the interval of about 5 min to about 55 min from the time of starting the heating (0 min), the alloy (2) was held within a fixed temperature range (about 199°C which is the eutectic temperature of 30Sn-70Zn), the open-circuit voltage of the thermoelectric conversion module 20 was maintained at about 3.5 to 4.0 V, therefore it was possible to confirm that the open-circuit voltage of the thermoelectric conversion module 20 followed the temperature of the alloy (2).

### Example 10

In Example 10, the alloys (1) and (2) were respectively filled into two spaces of 60 mm x 60 mm x 15 mm of the heat resistant frame, and a 30Sn-70Zn was used as the alloys (1) and (2), and intermittent heating was carried out with a burner.

Further, in Example 10, the same module as in Example 7 was used as the thermoelectric conversion module 20.

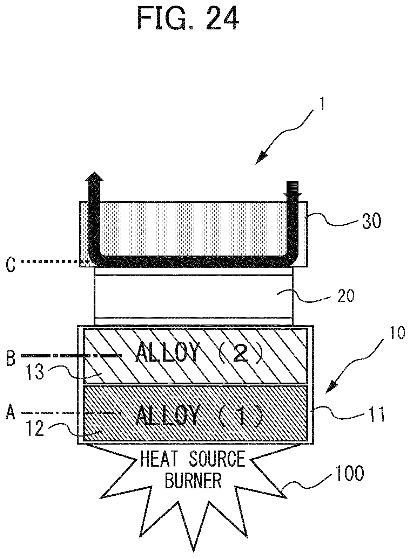

Fig. 24 is a drawing showing the positions for providing the thermocouples in the thermal energy conversion system 1 of Example 10.

The thermocouple provided at the measurement location A (the long-and-short dashed line in Fig. 24) measures the temperature changes of the alloy (1).

The thermocouple provided at the measurement location B (the thick long-and-short dashed line in Fig. 24) measures the temperature changes of the alloy (2).

The thermocouple provided at measurement location C (the dotted line in Fig. 24) measures the temperature changes of the cooling portion cooled by the coolant of the cooling device 30.

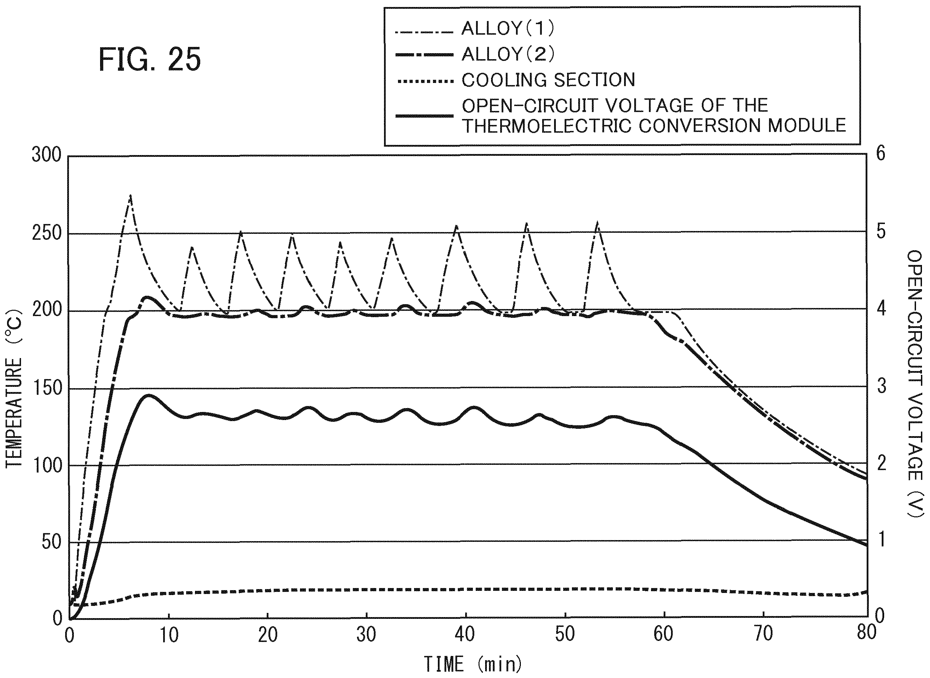

Fig. 25 is a drawing showing the temperature changes of the predetermined locations of the thermal energy conversion system 1 in Example 10. Each of the lines in Fig. 25 is explained below.

The long-and-short dashed line indicates the temperature changes of the alloy (1) measured at the measurement location A.

The long-and-two-short dashed line indicates the temperature changes of the alloy (2) measured at the measurement location B.

The dotted line indicates the temperature changes of the cooling portion cooled by the coolant of the cooling device 30 measured at the measurement location C.

The solid line indicates the changes of the open-circuit voltage of the thermoelectric module 20.

As shown in Fig. 25, in the interval of about 5 min to about 55 min from the starting time of the heating (0 min), the alloy (2) was held within a fixed temperature range (about 199°C which is the eutectic temperature of 30Sn-70Zn), and the open-circuit voltage of the thermoelectric conversion module 20 was maintained at about 2.5 V, therefore it was possible to confirm that the open-circuit voltage of the thermoelectric conversion module 20 followed the temperature of the alloy (2).

Further, in Example 9 and Example 10, the size of the heat resistant frame is smaller than in Example 7 and Example 8, and the amount of the filled alloy is about 1/10, therefore the temperature variations that can be absorbed are smaller, and as a result, the variations in the open-circuit voltage of the thermoelectric conversion module 20 are greater than in Example 7 and Example 8. Therefore, such a thermal energy conversion system of small size is preferably applied in the case that the temperature variations of the heat source are small, and in the case that there are constraints on the installation size. Further, if necessary, a plurality of heat resistant frames or thermal energy conversion systems may be combined, or a plurality of heat resistant frames or thermal energy conversion systems may be connected and used.

### Example 11

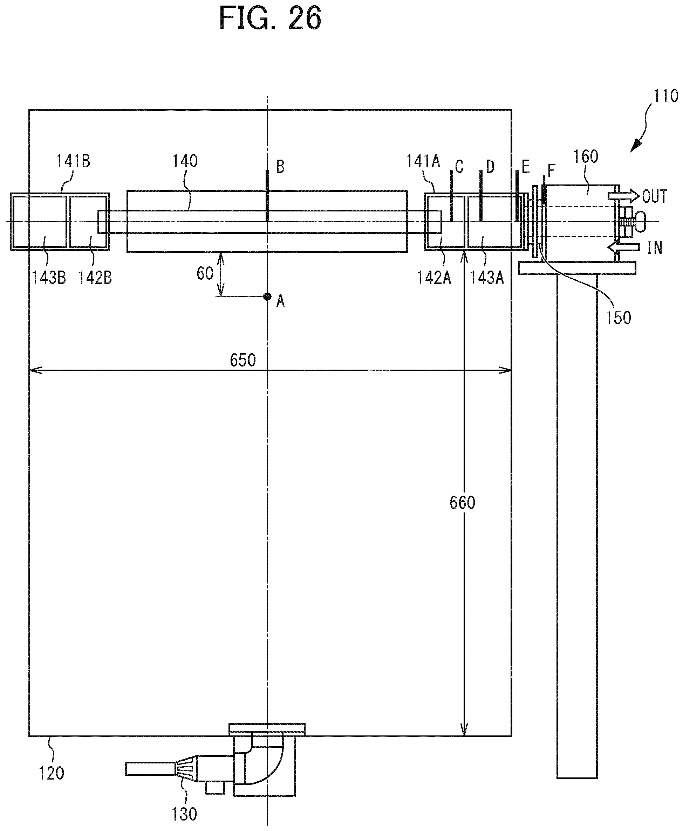

Example 11 assumes the absorption of heat from the atmosphere of a chimney, and its conversion to electric power, and is constituted of the thermal energy conversion system 110 as shown in Fig. 26.

As shown in Fig. 26, the lower portion of a chimney 120 of 650 mm x 850 mm was heated with a burner 130, and the atmosphere escapes upwards. An aerofin tube 140 (inner diameter ϕ 27 mm, outer diameter ϕ 65 mm) for heat absorption was disposed at the inner portion of the chimney 120, and a 15Al-85Zn alloy of the high temperature side was filled into its inner portion. Further, heat storage frames 141A, 141B (70 mm x 70 mm x 100 mm) are connected at both ends of the aerofin tube 140. The inner portions of the heat storage frames 141A and 141B are each divided into two spaces of the heat absorption-side heat storing sections 142A, 142B, and the heat dissipation-side heat storing sections 143A, 143B, and a 15Al-85Zn alloy of the high temperature side is filled into the heat absorption-side heat storing sections 142A and 142B, and a 30Sn-70Zn alloy of the low temperature side is filled into the heat dissipation-side heat storing sections 143A, 143B.

A thermoelectric conversion module 150 is disposed at the heat dissipation side of the heat storage frame 141A, and a cooling device 160 is further disposed at the low temperature side of the thermoelectric conversion module 150. The heat storage frame 141A, the thermoelectric conversion module 150, and the cooling device 160 are fixed with M10 bolts.

The thermoelectric conversion module 150 uses the following modules.
Product name: Thermo•Module
Model no.: T150-60-127
Manufacturer name: S. T. S. Company
Constitution:
   1. Thermoelectric elements: Bi-Te system (actual measured size: about □1.3 x 1.5 mm)
   2. Number of elements: 254 (127 pairs)
   3. Module size: 39.6 x 39.6 x 4.16 (mm)

Further, a thermally conductive sheet (graphite sheet) is sandwiched between the thermoelectric conversion module 150 and the heat storage frame 141A. Furthermore, grease (Dow Corning Toray Co. Ltd.: SC102 COMPOUND (thermally conductive material)) was applied at the electrode of the cooling device 160 side of the thermoelectric conversion module 150.

Further, in order to measure the temperature changes, thermocouples are provided at the measurement location indicated by A to F in Fig. 26.

The measurement location A is a position 60 mm below the aerofin tube 140, and measures the atmospheric temperature in the central portion of the chimney 120.

The measurement location B measures the alloy temperature inside the aerofin tube 140.

The measurement location C measures the alloy temperature inside the heat absorption-side heat storing section 142A.

The measurement location D measures the alloy temperature of a portion in the vicinity of the heat absorption-side heat storing section 142A, in the inside of the heat dissipation-side heat storing section 143A.

The measurement location E measures the alloy temperature of a portion in the vicinity of the thermoelectric conversion module 150, in the inside of the heat dissipation-side heat storing section 143A.

The measurement location F measures the temperature of the cooling water flowing in the cooling device 160.

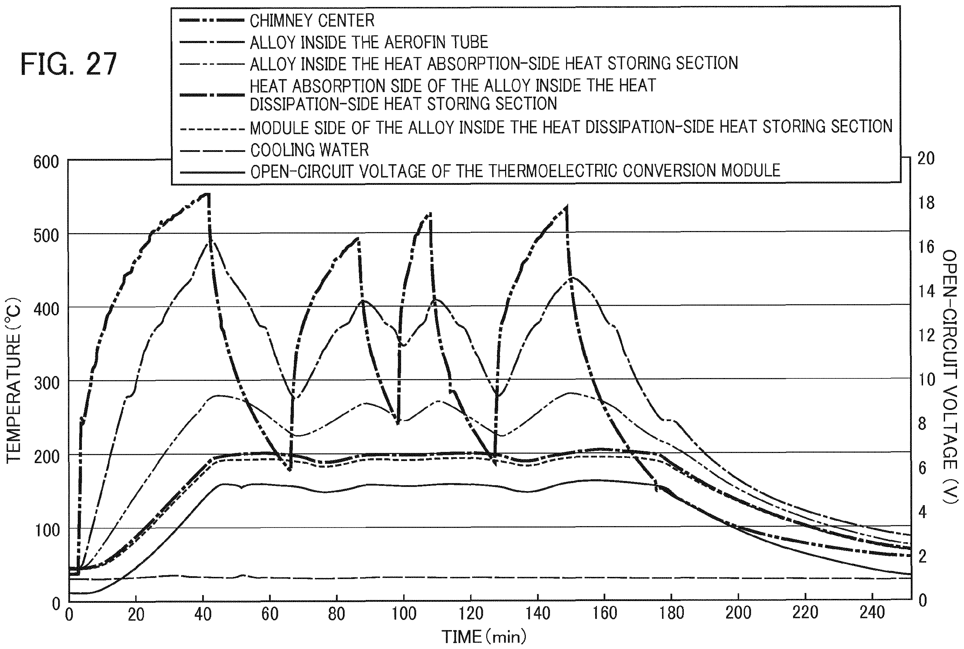

The temperature changes of each of the measurement locations when the chimney 120 was intermittently heated by the burner 130, and the changes of the open-circuit voltage of the thermoelectric conversion module 150 are shown in Fig. 27.

As shown in Fig. 27, at about 40 to about 50 min from the start time of the heating (0 min), the atmospheric temperature in the central portion of the chimney 120 reached up to 550°C, but because the alloy of the aerofin tube 140 and the heat absorption-side heat storing section 142A absorbs heat at the eutectoid temperature (275°C) and the eutectic temperature (382°C), the temperature increase of the alloy of the aerofin tube 140 and the heat absorption-side heat storing section 142A is gradual. Further, after temporarily stopping the heating after about 50 min, because of heat generation at the eutectoid temperature (275°C) and eutectic temperature (382°C), the temperature decrease of the alloy of the aerofin tube 140 and the heat absorption-side heat storing section 142A was not uniform.

Further, even when intermittently heating such that the atmospheric temperature in the central portion of the chimney 120 is within the range of 200 to 550°C, it was possible to confirm that the temperature of the alloy of the heat dissipation-side heat storing section 143A was held at about 199°C which is the eutectic temperature of 30Sn-70Zn, and the open-circuit voltage of the thermoelectric conversion module 150 was maintained at about 5 V.

Further, after fully stopping the heating, for a period of about 30 min, it was possible to confirm that the temperature of the alloy of the heat dissipation-side heat storing section 143A is held at about 199°C, and the open-circuit voltage of the thermoelectric conversion module 150 is maintained at about 5 V.

### Example 12

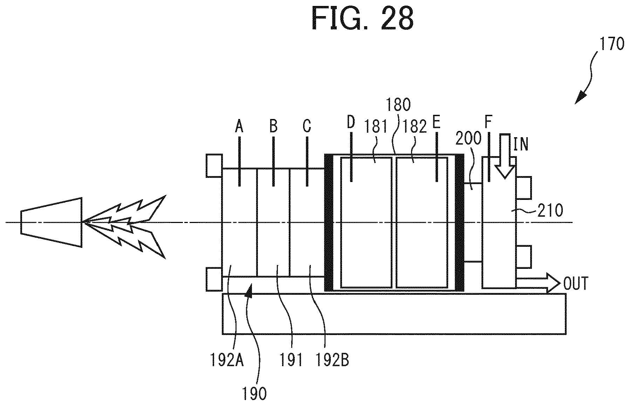

In Example 12, in order to confirm the effects of the thermal fuse, a thermal energy conversion system 170 was constituted as shown in Fig. 28.

As shown in Fig. 28, the inner portion of the heat storage frame 180 (60 mm x 60 mm x 60 mm) is divided into two spaces of the heat absorption-side heat storing section 181 and the heat dissipation-side heat storing section 182, and a 15Al-85Zn alloy of the high temperature side was filled into the heat absorption-side heat storing section 181, and a 30 Sn-70Zn alloy of the low temperature side was filled into the heat dissipation-side heat storing section 182.

At the high temperature side of the heat storage frame 180, a thermal fuse 190 was provided so as to sandwich a thermally conductive sheet (graphite sheet). The thermal fuse 190 is cylindrical, and is stored in a case (□60mm) made of a heat resistant material. The thermal fuse 190 is provided with a fusible alloy 191 of zinc having a fusion point of 419°C which is lower than the fusion point of 450°C of the 15Al-85Zn alloy, and retaining members 192A, 192B made of SS400 and which retain the fusible alloy 191. Further, the total thickness of the thermal fuse 190 is 30 mm, the thickness of the fusible alloy 191 is 6 mm, and the thickness of the retaining members 192A, 192B is 12 mm.

The thermoelectric conversion module 200 is disposed at the heat release side of the heat storage frame 180 so as to sandwich a thermally conductive sheet (graphite sheet), and a cooling device 210 is further provided at the low temperature side of the thermoelectric conversion module. As the thermoelectric conversion module 200, the same module as in Example 11 is used. Further, as the cooling device 210, a water cooled heat sink (manufactured by Takagi Manufacture: S-200W, made of oxygen free copper, 80 mm x 80 mm x 19 mm, surface roughness 1.6 a) was used. Furthermore, grease (Dow Corning Toray Co. Ltd.: SC102 COMPOUND (thermally conductive material)) was applied at the electrode of the cooling device 210 side of the thermoelectric conversion module 200.

Further, in order to measure the temperature changes, thermocouples were provided at the measurement locations indicated by A to F in Fig. 28.

The measurement location A measures the temperature of the retaining member 192A which is the heat receiving side.

The measurement location B measures the temperature of the fusible alloy 191.

The measurement location C measures the temperature of the retaining member 192B which is the heat transmitting side.

The measurement location D measures the alloy temperature of a portion in the vicinity of the thermal fuse 190, in the inside of the heat absorption-side heat storing section 181.

The measurement location E measures the alloy temperature of a portion in the vicinity of the thermoelectric conversion module 200, in the inside of the heat dissipation-side heat storing section 182.

The measurement location F measures the temperature of the cooling water flowing in the cooling device 210.

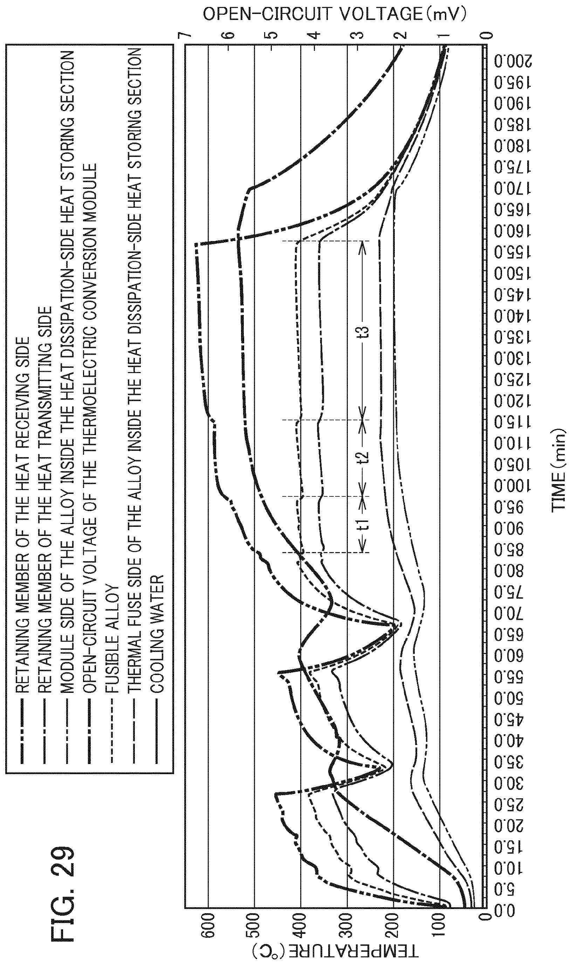

The temperature changes at each measurement location when intermittently heating the thermal fuse 190 of Fig. 28 by a burner, and the changes of the open-circuit voltage of the thermoelectric conversion module 200 are shown in Fig. 29.

As shown in Fig. 29, after two iterations of stopping the heating by the burner before reaching the temperature at which the fusible alloy 191 of the thermal fuse 190 fuses, continuous heating by the burner was performed to above the fusion temperature of the fusible alloy 191. By continuously heating, the temperature of the retaining member 192A of the heat receiving side of the thermal fuse 190 increases, and as the face contacting the fusible alloy 191 reaches a temperature close to the fusion point of the fusible alloy 191, the fusible alloy in the vicinity of this face gradually fuses, and ultimately falls under its own weight, and a gap arises between the retaining member 192A and the fusible alloy 191. As a result, the transmission of heat from the retaining member 192 becomes poor, the temperature of the fusible alloy 191 drops, and the fusion of the fusible alloy 191 temporarily stops. If further continuous heating is continued, the fusible alloy 191 reaches a temperature in the vicinity of the fusion point, the same phenomenon as above occurs, and the gap further increases. By this reiteration, the gap between the retaining member 192A and the fusible alloy 191 gradually increases. As a result, even when the fusible alloy 191 increases in temperature by about 100°C or more from first reaching the fusion temperature, the temperature of the fusible alloy 191 is held approximately fixed at the fusion temperature, the temperature of the retaining member 192B is also held approximately fixed, and a fixed temperature is transmitted to the heat storage frame 180. Because of this, it was possible to confirm that the role as a thermal fuse was accomplished.

Further, the time from when the temperature of the fusible alloy 191 drops, and the fusion of the fusible alloy 191 is temporarily stopped, until it next fuses and a gap arises is first the length t1 in Fig. 29, but it can be understood that as this is repeated, it becomes progressively longer in order of t2, t3.

### Example 13

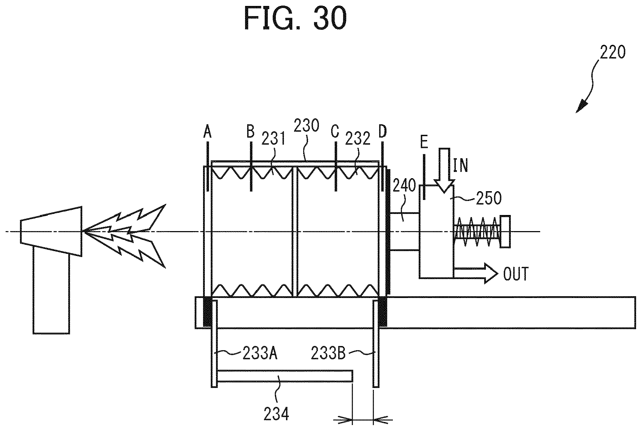

In Example 13, a thermal energy conversion system 220 was constituted as shown in Fig. 30 by using a bellows shaped expansion pipe (bellows) in the heat storage frame, in order to confirm the expansion operation. As shown in Fig. 30, the heat storage frame 230 (ϕ 120 mm x 120 mm) was constituted by welding a flange plate at both ends of a heat resistant bellows.

A partitioning plate is provided in the central portion of the heat storage frame 230, dividing the two spaces of the heat absorption-side heat storing section 231 and the heat dissipation-side heat storing section 232, and a 20Sn-80Zn alloy is filled into the heat absorption-side heat storing section 231, and an 80Sn-20Zn alloy is filled into the heat dissipation-side heat storing section 232.

The quartz glass plates 233A, 233B was integrally mounted on the flange plate, and the quartz glass rod 234 was mounted on the quartz glass plate 233A. Further, a contact type digital sensor, (KEYENCE CORPORATION, sensor head GT2-H12, amp GT2-70MCN), not shown in the drawings, made it possible to measure changes in the overall length of the heat storage frame 230 via the silica glass rod 234.

The thermoelectric conversion module 240 is disposed so as to sandwich a thermally conductive sheet (graphite sheet) at the heat dissipation side of the heat storage frame 230, and the cooling device 250 is further disposed at the low temperature side of the thermoelectric conversion module 240. The cooling device 250 presses against the thermoelectric conversion module 240 with a pressing force of about 4 kgF by a compression coil spring. As the thermoelectric conversion module, the same module as in Example 11 was used. Further, as the cooling device 250, a water cooled heat sink (manufactured by Takagi Manufacturing Co.: S-200W, made of oxygen free copper, 80 mm x 80 mm x 19 mm, surface roughness 1.6 a) was used. Furthermore, grease (Dow Corning Toray Co. Ltd.: SC102 COMPOUND (thermally conductive material)) was applied at the electrode of the cooling device 250 side of the thermoelectric conversion module 240.

Further, in order to measure the temperature changes, thermocouples were provided at the measurement locations indicated by A to E in Fig. 30.

The measurement location A measures the temperature of the flange plate of the burner side.

The measurement location B measures the alloy temperature inside the heat absorption-side heat storing section 231.

The measurement location C measures the alloy temperature inside the heat dissipation-side heat storing section 232.

The measurement location D measures the temperature of flange plate of the thermoelectric conversion module 240 side.

The measurement location E measures the temperature of the cooling water flowing inside the cooling device 250.

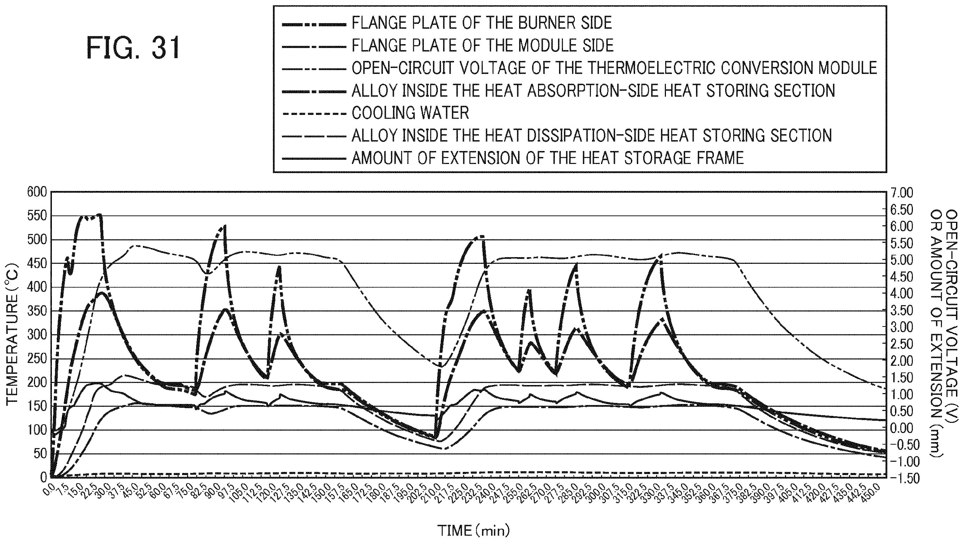

The temperature changes of each of the measurement locations when the thermal energy conversion system 220 shown in Fig. 30 was intermittently heated by the burner, and the changes of the open-circuit voltage of the thermoelectric conversion module 240, and the changes in the amount of extension of the heat storage frame 230 are shown in Fig. 31. Further, in Fig. 31, when the amount of extension is a positive value, this means that the heat storage frame 230 extended, and when the amount of extension is a negative value, this means that the heat storage frame 230 contracted.

As shown in Fig. 31, after heating to a maximum of about 550°C, even when intermittently heating within a range of about 200 to about 500°C, no malfunctions such as leakage of the alloy or damage in the heat storage frame 230 could be found. Further, the use of a bellows in the heat storage frame 230 had no influence on the heat storage effects, and as a result of holding in the vicinity of the eutectic temperature of the of the alloy inside the heat dissipation-side heat storing section 232, the open-circuit voltage of the thermoelectric conversion module 240 was stable at about 5.0 V.

It was possible to confirm that the heat storage frame 230 extends by a maximum of about 1 mm along with the temperature increase, and further, contracts along with the temperature decrease after the heating was stopped, in conformance with the heating cycle.

### Example 14

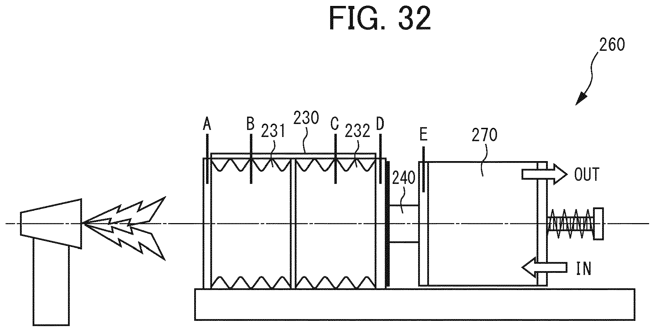

In Example 14, in order to confirm the influence by the type of cooling device, a thermal energy conversion system 260 as shown in Fig. 32 was constituted. As the cooling device 270, one where a mill scale adhering to the surface of a water cooling box manufactured of steel plates of SS400 was used, and in the same way as in Example 13, presses against the thermoelectric conversion module 240 with a pressing force of about 4 kgF by a compression coil spring. The other constituents are the same as in Example 13, therefore the same reference numbers are used and detailed explanations are omitted.

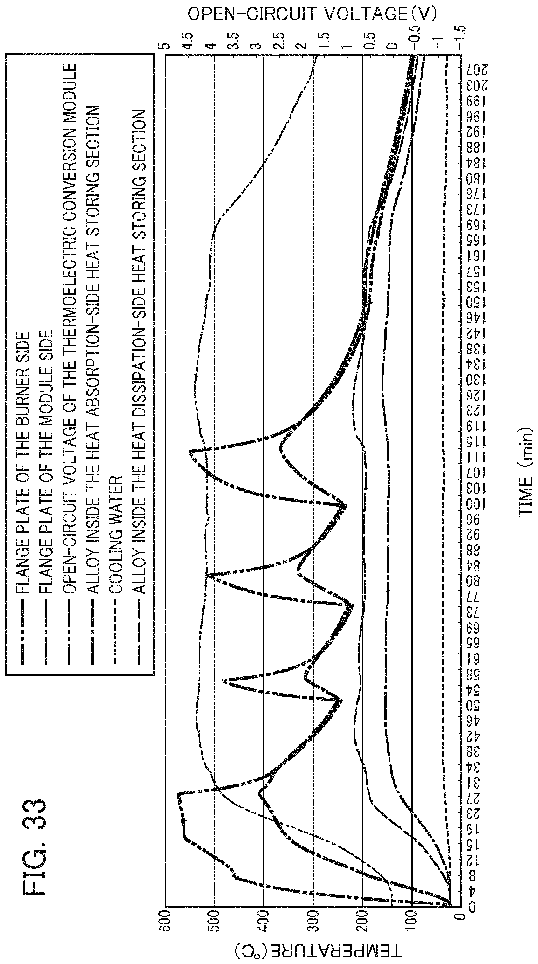

The temperature changes of each of the measurement locations when the thermal energy conversion system 260 shown in Fig. 32 was intermittently heated by the burner, and the changes of the open-circuit voltage of the thermoelectric conversion module 240, are shown in Fig. 33.

As shown in Fig. 33, after heating to a maximum of about 550°C, even when intermittently heating within a range of about 200 to about 500°C, no malfunctions such as leakage of the alloy or damage in the heat storage frame 230 could be found. Further, the use of a bellows in the heat storage frame 230 did not change the heat storage effects, and as a result of holding in the vicinity of the eutectic temperature of the alloy in the heat dissipation-side heat storing section 232, the open-circuit voltage of the thermoelectric conversion module 240 was stable at 4.0 to 4.5 V. Furthermore, compared to Example 13, the reduction in the open-circuit voltage of the thermoelectric conversion module 240 is surmised to be because of the higher thermal resistance in the case of using the cooling device 270, due to the difference in the surface roughness and surface characteristics of the cooling device.

### Example 15

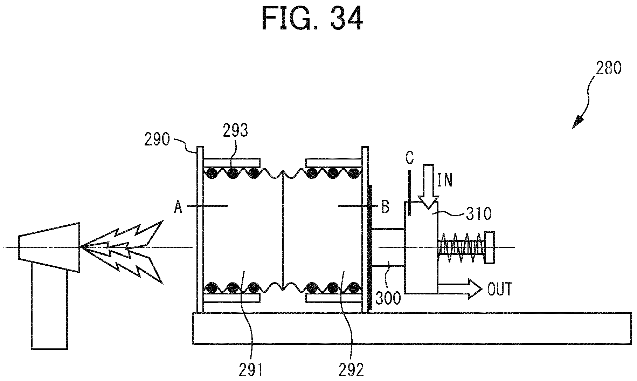

In Example 15, in order to investigate other constitutions using a bellows shaped expansion pipe (bellows) in the heat storage frame, a thermal energy conversion system 280 as shown in Fig. 34 was constituted.

As shown in Fig. 34, both ends of the heat resistant bellows are inserted into flanges having a cylinder of an inner diameter the same as the outer diameter of the bellows, to constitute the heat storage frame 290 (ϕ 120 mm x 120 mm). A partitioning plate is provided in the central portion of the heat storage frame 290, dividing the two spaces of the heat absorption-side heat storing section 291 and the heat dissipation-side heat storing section 292, a 20Sn-80Zn alloy is filled into the heat absorption-side heat storing section 291, and a 80Sn-20Zn alloy is filled into the heat dissipation-side heat storing section 292. Further, in order to prevent the leakage of the alloy from the gap of the flange, at the valley portions of the bellows, a fireproof rope 293 (ϕ 9 isowool rope) was wrapped around only three valley parts.

At the heat dissipation side of the heat storage frame 290, the thermoelectric conversion module 300 was disposed so as to sandwich a thermally conductive sheet (graphite sheet), and the cooling device 310 was further disposed at the low temperature side of the thermoelectric conversion module 300. The cooling device 310 pressed against the thermoelectric conversion module 300 with a pressing force of about 4 kgF by a compression coil spring. As the thermoelectric conversion module 300, the same module as in Example 11 was used. Further, as the cooling device 310, a water cooled heat sink (manufactured by Takagi Manufacturing Co.: S-200W, made of oxygen free copper, 80 mm x 80 mm x 19 mm, surface roughness 1.6 a) was used. Furthermore, grease (Dow Corning Toray Co. Ltd.: SC102 COMPOUND (thermally conductive material)) was applied at the electrode of the cooling device 310 side of the thermoelectric conversion module 300.

Further, in order to measure the temperature changes, thermocouples were provided at the measurement locations indicated by A to C in Fig. 34.

The measurement location A measures the alloy temperature inside the heat absorption-side heat storing section 291.

The measurement location B measures the alloy temperature inside the heat dissipation-side heat storing section 292.

The measurement location C measures the temperature of the cooling water flowing inside the cooling device 310.

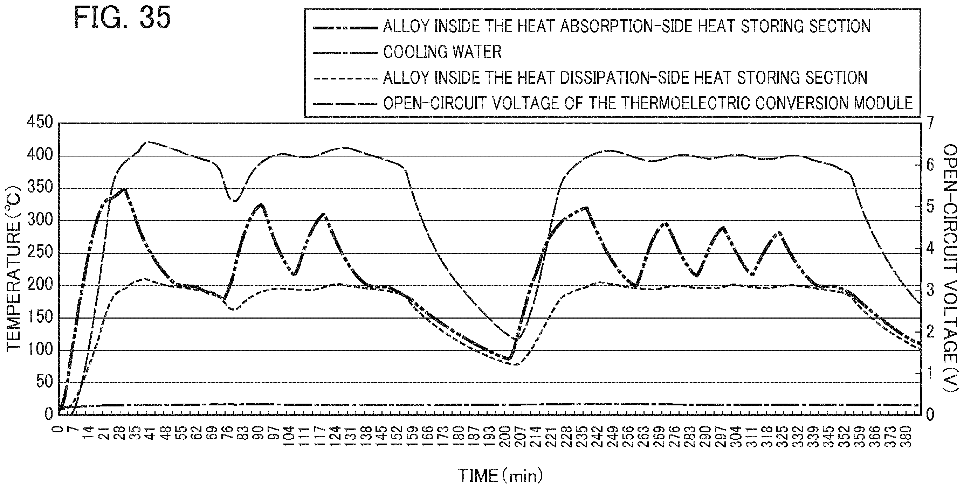

The temperature changes of each of the measurement locations when the thermal energy conversion system 280 shown in Fig. 34 was intermittently heated by the burner, and the changes of the open-circuit voltage of the thermoelectric conversion module 300, are shown in Fig. 35.

As shown in Fig. 35, intermittent heating to above the fusion temperature of the alloy (380°C) inside the heat absorption-side heat storing section 291 was repeated, but no malfunctions such as leakage of the alloy or damage in the heat storage frame 290 could be found. Further, not welding both ends of the bellows had no influence on the heat storage effects, and as a result of holding in the vicinity of the eutectic temperature of the alloy inside the heat dissipation-side heat storing section 292, the open-circuit voltage of the thermoelectric conversion module 300 was stable at 6.0 to 6.5 V.

Furthermore, the expansion of the heat storage frame 290 along with the temperature increase was one mountain part (about 5 mm) of the bellows.

## Claims

1. A heat storage device (10, 10A', 10B, 10C) which stores heat from a heat source (100), this heat being used for operating an energy conversion device, **characterized in that,** the heat storage device (10, 10A', 10B, 10C) comprises:
a heat resistant frame (11A) filled with one type of eutectic alloy or eutectic mixed salt having a eutectic temperature which is within a range of operating temperatures of the energy conversion device and within a temperature range of the heat source (100); or
a heat resistant frame (11, 11B) filled with two or more eutectic alloys or eutectic mixed salts having different eutectic temperatures and adjoining via a heat transmissive partitioning wall (11a) in order of higher eutectic temperature, wherein
one part of the heat resistant frame (11, 11B) is filled with the eutectic alloy or eutectic mixed salt having the highest eutectic temperature and where this eutectic temperature is within a temperature range of the heat source (100), and
another part of the heat resistant frame (11, 11B) is filled with the eutectic alloy or eutectic mixed salt having the lowest eutectic temperature and where this eutectic temperature is within an operating temperature range of the energy conversion device;
wherein a eutectic alloy or eutectic mixed salt in a solid-liquid coexistence state has a function of absorbing temperature fluctuations of the heat source (100).

2. A heat storage device (10, 10A', 10B, 10C) according to claim 1, wherein the heat resistant frame (11A) filled with the one type of eutectic alloy or eutectic mixed salt is a heat absorption section (12A) and a heat dissipation section (13), or among the heat resistant frames (11, 11B) filled with the two or more eutectic alloys or eutectic mixed salts, the part of the heat resistant frame (11, 11B) filled with the eutectic alloy or eutectic mixed salt having the highest eutectic temperature is the-heat absorption section (12), and the part of the heat resistant frame (11) filled with the eutectic alloy or eutectic mixed salt having the lowest eutectic temperature is the heat dissipation section (13).

3. A heat storage device (10A') according to claim 1 or 2, further comprising a heat collection part (12b).

4. A heat storage device (10C) according to any one of claims 1 to 3, wherein the heat resistant frame (11B) is an expandable structure.

5. A system (1, 1A, 1B) comprising:
a heat storage device (10, 10A', 10B, 10C) according to any one of claims 2 to 4, and
an energy conversion device connected to the heat dissipation section (13).

6. A system according to claim 5, wherein the energy conversion device is a thermoelectric conversion module (20).

7. A system (1, 1A, 1B) according to claim 5, wherein the energy conversion device is a Sterling engine.

8. A system (1, 1A, 1B) according to any one of claims 5 to 7, further comprising a thermal fuse (15) and/or a cooling section (30).

9. A method of using the system (1, 1A, 1B) according to claim 6, wherein heat is stored by absorbing heat in the heat absorption section (12, 12A), and the thermoelectric conversion module (20) is made to generate electricity with heat released from the heat dissipation section (13) as a heat source.

10. A method of using the system (1, 1A, 1B) according to claim 7, wherein heat is stored by absorbing heat in the heat absorption section (12, 12A), and the Sterling engine is operated with heat released from the heat dissipation section (13) as a heat source.

## Patentansprüche

1. Eine Wärmespeichervorrichtung (10, 10A', 10B, 10C), die Wärme von einer Wärmequelle (100) speichert, wobei die Wärme zum Betrieb einer Energieumwandlungsvorrichtung verwendet wird, **dadurch gekennzeichnet, dass** die Wärmespeichervorrichtung (10, 10A', 10B, 10C) umfasst:
einen hitzebeständigen Rahmen (11A), der mit einer Art von eutektischer Legierung oder eutektischer Salzmischung gefüllt ist, deren eutektische Temperatur innerhalb des Betriebstemperaturbereichs der Energieumwandlungsvorrichtung und innerhalb des Temperaturbereichs der Wärmequelle (100) liegt, oder
einen hitzebeständigen Rahmen (11, 11B), der mit zwei oder mehr eutektischen Legierungen oder eutektischen Salzmischungen mit unterschiedlichen eutektischen Temperaturen gefüllt ist, und die in aufsteigender Reihenfolge der immer höher werdenden eutektischen Temperatur über eine wärmeübertragende Trennwand (11a) aneinander angrenzen, wobei
ein Teil des hitzebeständigen Rahmens (11, 11B) mit der eutektischen Legierung oder der eutektischen Salzmischung mit der höchsten eutektischen Temperatur gefüllt ist, und wobei diese eutektische Temperatur innerhalb des Temperaturbereichs der Wärmequelle (100) liegt, und
ein anderer Teil des hitzebeständigen Rahmens (11, 11 B) mit der eutektischen Legierung oder der eutektischen Salzmischung mit der niedrigsten eutektischen Temperatur gefüllt ist, und wobei diese eutektische Temperatur innerhalb des Betriebstemperaturbereichs der Energieumwandlungsvorrichtung liegt,
wobei die eutektische Legierung oder die eutektische Salzmischung in einem fest-flüssig-Gleichgewichtszustand vorliegt und eine Funktion beim Absorbieren von Temperaturschwankungen der Wärmequelle (100) hat.

2. Die Wärmespeichervorrichtung (10, 10A', 10B, 10C) gemäß Anspruch 1, wobei der hitzeresistente Rahmen (11A), der mit der einen Art von eutektischer Legierung oder eutektischer Salzmischung gefüllt ist, einen wärmeaufnehmenden Abschnitt (12A) und einen wärmeabgebenden Abschnitt (13) aufweist, oder wobei von den hitzeresistenten Rahmen (11, 11B), die mit den zwei oder mehr eutektischen Legierungen oder eutektischen Salzmischungen gefüllt sind, der Teil des hitzeresistenten Rahmens (11, 11B), der mit der eutektischen Legierung oder der eutektischen Salzmischung mit der höchsten eutektischen Temperatur gefüllt ist, der wärmeaufnehmende Abschnitt (12) ist, und der Teil des hitzeresistenten Rahmens (11), der mit der eutektischen Legierung oder der eutektischen Salzmischung mit der niedrigsten eutektischen Temperatur gefüllt ist, der wärmeabgebende Abschnitt (13) ist.

3. Die Wärmespeichervorrichtung (10A') gemäß einem der Ansprüche 1 oder 2, zusätzlich umfassend einen Wärmesammelteil (12b).

4. Die Wärmespeichervorrichtung (10C) gemäß einem der Ansprüche 1 bis 3, wobei der hitzeresistente Rahmen (11B) eine erweiterbare Struktur darstellt.

5. Ein System (1, 1A, 1B) umfassend:
eine Wärmespeichervorrichtung (10, 10A', 10B, 10C) gemäß einem der Ansprüche 2 bis 4, und eine Energieumwandlungsvorrichtung, die mit dem wärmeabgebenden Abschnitt (13) verbunden ist.

6. Ein System (1, 1A, 1B) gemäß Anspruch 5, wobei die Energieumwandlungsvorrichtung ein thermoelektrisches Umwandlungsmodul (20) ist.

7. Das System (1, 1A, 1B) gemäß Anspruch 5, wobei die Energieumwandlungsvorrichtung ein Sterlingmotor ist.

8. Das System (1, 1A, 1B) gemäß einem der Ansprüche 5 bis 7, zusätzlich umfassend eine thermische Sicherung (15) und/oder einen Kühlabschnitt (30).

9. Ein Verfahren zur Verwendung des Systems (1, 1A, 1B) gemäß Anspruch 6, wobei die Wärme durch Absorbieren der Wärme innerhalb des wärmeaufnehmenden Abschnitts (12, 12A) gespeichert wird, und das thermoelektrische Umwandlungsmodul (20) ausgelegt ist, um mit Wärme, die von dem wärmeabgebenden Abschnitt (13) als Wärmequelle abgegeben wird, Elektrizität zu erzeugen.

10. Das Verfahren zur Verwendung des Systems (1, 1A, 1B) gemäß Anspruch 7, wobei die Wärme durch Absorption der Wärme in dem energieaufnehmenden Abschnitt (12, 12A) gespeichert wird, und der Sterlingmotor durch Wärme, die von dem wärmeabgebenden Abschnitt (13) als Wärmequelle abgegeben wird, betrieben wird.

## Revendications

1. Dispositif d'accumulation de chaleur (10, 10A', 10B, 10C) qui accumule de la chaleur provenant d'une source de chaleur (100), ladite chaleur servant à mettre en œuvre un dispositif de conversion d'énergie, **caractérisé en ce que** le dispositif d'accumulation de chaleur (10, 10A', 10B, 10C) comprend :
un bâti thermorésistant (11A) rempli d'un type d'alliage eutectique ou d'un sel mélangé eutectique ayant une température eutectique qui s'inscrit dans une plage de températures de fonctionnement du dispositif de conversion d'énergie et dans une plage de températures de la source de chaleur (100) ; ou
un bâti thermorésistant (11, 11B) rempli d'au moins deux alliages eutectiques ou sels mélangés eutectiques ayant des températures eutectiques différentes et se rejoignant par le biais d'une paroi de séparation laissant passer la chaleur (11a) en un ordre de température eutectique plus haute, dans lequel
une partie du bâti thermorésistant (11, 11B) est remplie de l'alliage eutectique ou du sel mélangé eutectique ayant la température eutectique la plus haute et dans lequel cette température eutectique s'inscrit dans une plage de températures de la source de chaleur (100), et
une autre partie du bâti thermorésistant (11, 11B) est remplie de l'alliage eutectique ou du sel mélangé eutectique ayant la température eutectique la plus basse et dans lequel cette température eutectique s'inscrit dans une plage de températures de fonctionnement du dispositif de conversion d'énergie ;
dans lequel un alliage eutectique ou un sel mélangé eutectique dans un état de coexistence solide-liquide assure une fonction d'absorption de fluctuations de température de la source de chaleur (100).

2. Dispositif d'accumulation de chaleur (10, 10A', 10B, 10C) selon la revendication 1, dans lequel le bâti thermorésistant (11A) rempli du premier type d'alliage eutectique ou de sel mélangé eutectique est une section d'absorption de chaleur (12A) et une section de dissipation de chaleur (13), ou parmi les bâtis thermorésistants (11, 11B) remplis des au moins deux alliages eutectiques ou des au moins deux sels mélangés eutectiques, la partie du bâti thermorésistant (11, 11B) rempli de l'alliage eutectique ou du sel mélangé eutectique ayant la température eutectique la plus haute est la section d'absorption de chaleur (12), et la partie du bâti thermorésistant (11) rempli de l'alliage eutectique ou du sel mélangé eutectique ayant la température eutectique la plus basse est la section de dissipation de chaleur (13).

3. Dispositif d'accumulation de chaleur (10A') selon la revendication 1 ou la revendication 2, comprenant en outre une partie de collecte de chaleur (12b).

4. Dispositif d'accumulation de chaleur (10C) selon l'une quelconque des revendications 1 à 3, dans lequel le bâti thermorésistant (11B) est une structure pouvant se dilater.

5. Système (1, 1A, 1B), comprenant :
un dispositif d'accumulation de chaleur (10, 10A', 10B, 10C) selon l'une quelconque des revendications 2 à 4, et
un dispositif de conversion d'énergie en communication avec la section de dissipation de chaleur (13).

6. Système selon la revendication 5, dans lequel le dispositif de conversion d'énergie est un module de conversion thermoélectrique (20).

7. Système (1, 1A, 1B) selon la revendication 5, dans lequel le dispositif de conversion d'énergie est un moteur Stirling.

8. Système (1, 1A, 1B) selon l'une quelconque des revendications 5 à 7, comprenant en outre un fusible thermique (15) et/ou une section de refroidissement (30).

9. Procédé d'utilisation du système (1, 1A, 1B) selon la revendication 6, dans lequel de la chaleur est accumulée par absorption de chaleur dans la section d'absorption de chaleur (12, 12A), et le module de conversion thermoélectrique (20) est amené à générer de l'électricité au moyen de la chaleur libérée de la section de dissipation de chaleur (13) en tant que source de chaleur.

10. Procédé d'utilisation du système (1, 1A, 1B) selon la revendication 7, dans lequel de la chaleur est accumulée par absorption de chaleur dans la section d'absorption de chaleur (12, 12A), et le moteur Stirling est mis en œuvre au moyen de la chaleur libérée de la section de dissipation de chaleur (13) en tant que source de chaleur.
